(19) Europäisches Patentamt
European Patent Office
Office européen des brevets

(11) EP 1 734 794 A1

(12) EUROPEAN PATENT APPLICATION
published in accordance with Art. 158(3) EPC

(43) Date of publication:
**20.12.2006 Bulletin 2006/51**

(21) Application number: **04725987.4**

(22) Date of filing: **06.04.2004**

(51) Int Cl.:
***H05B 33/28*** *(2006.01)* ***H05B 33/14*** *(2006.01)*
***H05B 33/02*** *(2006.01)* ***H05B 33/12*** *(2006.01)*
***H01B 5/14*** *(2006.01)* ***G09F 9/30*** *(2006.01)*

(86) International application number:
**PCT/JP2004/004971**

(87) International publication number:
**WO 2005/101915 (27.10.2005 Gazette 2005/43)**

(84) Designated Contracting States:
**DE FR GB**

(71) Applicant: **IDEMITSU KOSAN COMPANY LIMITED**
**Tokyo 100-0005 (JP)**

(72) Inventors:
- **Tokairin, Hiroshi**
**Central Research Labs.**
**Sodegaura-shi Chiba 2990205 (JP)**
- **Nagasaki, Yoshikazu,**
**Central Research Labs.**
**Sodegaura-shi,**
**Chiba 2990205 (JP)**
- **Shibuya, Tadao,**
**Central Research Labs.**
**Sodegaura-shi,**
**Chiba 2990205 (JP)**

(74) Representative: **Gille Hrabal Struck Neidlein Prop Roos**
**Brucknerstrasse 20**
**40593 Düsseldorf (DE)**

# (54) ELECTRODE SUBSTRATE AND ITS MANUFACTURING METHOD

(57) The purpose is to remove surface-defective layer existing on the surface of an anode on a CCM substrate, protect the anode surface, prevent a drive voltage of an organic EL element from rising, and maintain uniformity of luminescence. On a substrate (12) a CCM layer (14) for converting light wavelength is formed. On the CCM layer (14) an anode (16) of IZO is formed. On the anode (16) a surface protective layer (18) containing an inorganic compound is formed by an inductively coupled RF plasma support magnetron sputtering. A preferable inorganic compound is $SiO_2$. The surface defective layer of the anode (16) can be removed by sputtering and the state of being removed can be held by the inorganic compound. Therefore the electrical stability of the anode (16) can be maintained for a long time, thereby improving the display quality of an organic EL display (100).

Fig. 1

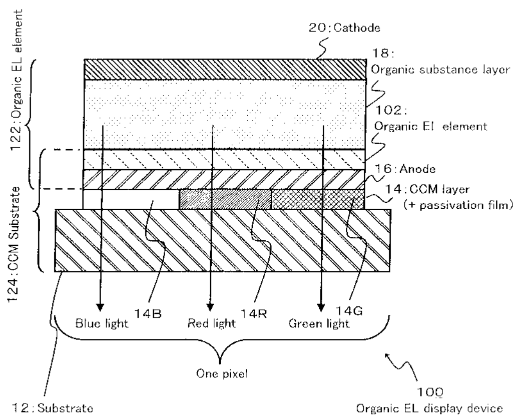


EP 1 734 794 A1

**Description**

Technical Field

The present invention relates to a structure of a substrate of an organic EL element, and a method for producing the same. In particular, the invention relates to an electrode substrate used in an organic EL element using the CCM method. More specifically, the invention relates to a color changing (CCM) substrate in which a measure is taken against a deterioration in the surface of a transparent electrode which is an anode of the substrate.

Background Art

A. [Technical Background]

In recent years, attention has been paid to organic EL (electroluminescence) elements from the viewpoint of application thereof to light emitting devices or display devices. For example, there has been advanced the use thereof as color and full-color display devices in information display instruments, on-vehicle display devices, or the like.

(1) Basic structure of an organic EL element

In general, an organic EL element has a structure in which a transparent electrode is used as an anode, Al (aluminum) or the like is used as a counter electrode (cathode), and an organic substance layer is sandwiched between the two electrodes. Various applications of such an organic EL element have been supposed. In particular, the application thereof to color displays has been greatly expected.

(2) CCM method

The present invention relates in particular to an organic EL element to which the CCM (color changing medium) method is applied. The CCM method is one of the methods for colorizing display devices. In the case of using an organic EL element to make a color display device, it is supposed to use, for example, an organic substance which emits light rays in the three primary colors (red, blue and green). However, when three organic substances (hereinafter referred to merely as the organic substances) are used, the production process becomes complicated. Thus, it is desired that a color display device can be completed by use of only one organic substance. The CCM method is a method contrived on the basis of this desire, and is a method of using a fluorescence converting layer to convert a light ray in a single color (for example, blue) which one organic substance emits appropriately into light rays having different wavelengths (for example, red and green), thereby producing the three primary colors.

This CCM method is one of the most promising methods for colorizing display devices from the viewpoint of production costs and an increase in the minuteness of patterns (full colorization). In this CCM method, not only the fluorescence converting layer but also a color filter are used to make the purity of the emitted calors high in some cases. In other words, it is known to use a fluorescence converting layer and/or a color filter layer to change the emitted colors of an organic EL.

A schematic sectional view illustrating a basic structure of an organic EL display device 10 using the CCM method is shown in Fig. 4. As illustrated in this figure, a CCM layer 14 is formed on a transparent glass substrate 12. This CCM 14 includes a green CCM layer 14G for emitting green fluorescence, a red CCM layer 14R for emitting red fluorescence, and a blue CCM layer 14B made of a transparent material which transmits blue light which an organic substance layer 18 emits as it is. A single pixel on a screen as a display device is composed of the green CCM layer 14G, the red CCM layer 14R, and the blue CCM layer 14B.

An anode 16, which is a transparent electrode, is laminated on the CCM layer 14. As the anode 16, ITO (indium tin oxide) or IZO (indium zinc oxide) is used. The organic substance layer 18 and a cathode 20 (for example, aluminum (Al)) are successively formed on the anode 16. This organic substance layer 18 emits light when an electric field is applied thereto. Thus, the layer 18 is called the light emitting layer in some cases.

In many cases, the organic substance layer 18 which emits blue is used in the organic EL display device 10 of the CCM type. This blue light is wavelength-converted into green light through the green CCM layer 14G, and is wavelength-converted into red light through the red CCM layer 14R. On the other hand, the blue CCM layer 14B is caused to transmit the blue light which the organic substance layer 18 emits as it is. Such a structure makes it possible to give the three primary colors of light, i.e., red, blue, and green.

In Fig. 4 and the above description, only the basic structure of the organic EL display device 10 of the CCM system has been stated. Actually, however, the CCM layer 14 includes a color filter to improve the purity of the colors in many cases. Indeed, the following device also is widely used: a device in which an electron injecting layer or a hole

injecting layer is fitted to the organic substance layer 18 to supply electrons from the cathode 20 or holes from the anode 16 effectively to the light emitting layer (organic substance layer 18).

In the organic EL display device 10, the structure from the anode 16 to the cathode 20 is particularly called an "organic EL element 22". Specifically, the element 22 is composed of the anode 16, the organic substance layer 18 and the cathode 20.

In the organic EL display device 10, the structure from the substrate 12 to the anode 16 is called an "electrode substrate", which has a meaning of the substrate with the electrode. From this electrode substrate, the organic EL display device 10 can easily be produced by laminating an organic substance constituting an EL element and a cathode on the electrode substrate. Furthermore, in the case that the CCM layer 14 is formed between the substrate 12 and the anode 16, the CCM type organic EL display device 10 can easily be produced. The electrode substrate in this case is particularly called a CCM substrate 24. Specifically, the electrode substrate composed of the substrate 12, the CCM layer 14, and the anode 16 is called the CCM substrate 24.

(3) Defective surface layer on the anode

An organic EL element is formed over a substrate; in the case of adopting the CCM method, a fluorescence converting layer and/or a color filter layer is/are formed on the substrate, as described above. Furthermore, an anode is formed on this fluorescence converting layer or the like. Subsequently, an organic substance and a cathode are successively laminated thereon, thereby forming the organic EL element over the substrate.

In the case of using the CCM method as described above, the substrate, and the fluorescence converting layer and/or color filter layer and the anode, which are laminated on the substrate, are together called the CCM substrate 24. As the anode 16 constituting this CCM substrate 24, a transparent electrode, such as IZO (indium zinc oxide) is used. The present inventors have advanced research on the generation of a defective surface layer on this anode, and the following has been made evident:

[1] In the case of producing a CCM substrate, the number of steps for producing the substrate is large so that contamination of the substrate advances easily and a defective surface layer is easily generated on the surface of its anode. In particular, the surface of a transparent electrode of IZO or the like is easily damaged by an excessive washing step or residues resulting from etching for patterning. Furthermore, water is adsorbed on the surface of the electrode, or a trace amount of impurity atoms contained in the bulk (the inner portion except the surface moiety) of the electrode precipitates on the surface, whereby the so-called defective surface layer tends to be generated on the anode.

[2] Furthermore, about the CCM (fluorescence converting layer) itself, a large portion thereof is made of a resin. Volatile gas components, such as water content, from this resin gradually contaminate the anode surface.

(4) It has been made evident from the present inventors' research that the following phenomena are caused by the presence of such a defective surface layer:

[1] The driving voltage of the organic EL element becomes large. That is, what is called EL performance declines.

[2] The luminescence uniformity of the organic EL element declines. Specifically, in the case of forming a CCM panel (a display panel in which the organic EL element using the CCM method is used), shrinkage development of each of its pixels is observed.

[3] In the case that acceleration evaluation of the CCM panel is made in a heating environment, a phenomenon that the rate of pixel shrinkage is made large (for example, heating environments of about 85°C and other temperature are used).

Problems as described above have been made evident by the inventors' research.

(5) Improvement in the anode in the prior art

Hitherto, various contrivances for improving the adhesiveness and electroconductivity between the anode 16 of the organic EL element and the organic substance laminated on the anode have been made.

One of the contrivances is a method of inserting an organic compound, or an inorganic substance such as a metal or semiconductor, as a buffer layer, between the anode 16 and the organic substance layer. Research on this method has widely been advanced from considerably old times.

However, this method of inserting the buffer layer does not give any action of reforming a deterioration in the

surface of the transparent electrode (anode), as described in the above items (3) and (4). Thus, the deterioration in the anode surface cannot be reformed only by the method of inserting the buffer layer; accordingly, there would be a limit to the advantageous effect thereof.

B. [Examples of documents in the prior art]

Next, the prior art will be introduced with reference to specific documents in the prior art, and the contents thereof, drawbacks and problems thereof, and so forth will be described.

(1) Passivation film

For example, WO 0072637 A1 (hereinafter referred to as the document 1) discloses an organic EL display using the CCM method and comprising a barrier film (= passivation film) made of silicon oxide.

According to this document 1, it is first stated that a substrate and a CCM layer (containing a color filter layer) thereon are covered with an organic layer for flattening, so as to make the surface thereof flat, whereby "breaking" and so forth are not generated even if an organic EL element is laminated thereon.

In the case that the surface on which an organic EL element is to be laminated has differences in level, discontinuous portions may be generated in a film of the laminated organic EL element. The discontinuous portions are called "breaking". As examples of the flattening organic layer, the document 1 describes examples of thermosetting resins and ultraviolet curable resins.

Furthermore, the document 1 points out that: in the case that an organic EL element is laminated directly onto the flattening organic layer, components of the flattening organic layer are volatilized by action of heat when the organic EL is laminated or is driven; and it appears that the components produce a bad effect on each of constituting materials of the organic EL. The document 1 also points out that it is assumed that the bad effect results in the following: non-luminous areas called dark spots are generated, or luminescence having a given quality cannot be maintained.

Thus, this document 1 states that when a barrier layer (passivation film) made of SiOx is interposed between the flattening organic layer and the organic EL element, the components of the flattening organic layer are prevented from diffusing into each of the layer materials of the organic EL element so that the element is prevented from being deteriorated.

However, this barrier layer (passivation layer) is effective for the prevention of the diffusion of the volatile components from the organic layer and the CCM layer. However, this layer would hardly produce an advantageous effect against the incorporation of water content or the like from any other portion than the CCM layer.

It is considered that the water content incorporated into the element is adsorbed between the anode 16 and the organic substance layer, so as to make the adhesiveness low, thereby deteriorating the injectable property of electric charges. As a result, it is presumed that what is called a defective surface layer of the anode is produced. The present invention is an invention for realizing a manner of suppressing the generation of such a defective surface layer (surface protective layer).

(2) Lamination of the buffer layer on the anode

Objects or purposes of the buffer layer laminated on the anode are a layer for improving the adhesiveness, a layer for improving the electroconductivity by action of an inorganic material, a layer in which a thin film layer of an insulator is used, a layer obtained by subjecting the surface of the anode to reverse sputtering, and so forth. These will be successively described hereinafter.

[1] Buffer layer inserted to improve the adhesiveness between the anode and the organic substance layer (adhesive property of the organic substance)

Japanese Patent Application Laid-Open (JP-A) No. 10-214683 (hereinafter referred to as the document 2) discloses that an anode and an organic substance layer are not satisfactorily jointed to each other because of a difference in crystal state between polycrystalline ITO (indium tin oxide) and the organic substance, so that joint failure is partially caused, thereby resulting in such problems that dark spots may be generated, and the organic substance layer is deteriorated by heat generated in the joint failure portions.

In order to solve these problems, in the document 2, an electroconductive joint-improving layer (an amorphous layer made of a metal such as Au or Pt, a metal oxide such as MoOx, VOx, SnOx, InOx or BaOx, a conjugated polymer, or the like) is formed into a film thickness of 1 to 500 $\mu$m.

JP-A-9-324176 (hereinafter referred to as the document 3) discloses a technique of improving the adhesiveness between an electrode and an organic film to prevent the generation of non-luminous portions, thereby improving the

long-term storability or the half value period of continuous driving. In order to attain such an object, the document 3 discloses a technique of interposing a layer made of a material obtained by substituting terminals of a compound used as a hole injecting/transporting material in the prior art with silane coupling groups.

JP-A-9-204985 (hereinafter referred to as the document 4) discloses a technique of subjecting an ITO electrode itself to surface treatment with a titanate based coupling agent from the same viewpoint as in the document 3.

[2] Buffer layer in which an inorganic material (a semiconductor or a conductor) is used to aim an improvement in the electroconductivity, and others

JP-A-3-105898 (hereinafter referred to as the document 5) discloses a technique of making a hole transporting layer or an electron transporting layer, which is usually made of an organic substance, by use of a P-type or N-type amorphous semiconductor which gives a good film state, so as to improve luminous performance.

JP-A-10-260062 (hereinafter referred to as the document 6) discloses a structure in which a mixture layer made of ITO and an inorganic semiconductor is formed instead of using an expensive hole injecting/transporting material, so as to set the resistivity to 20 Ωcm or less. Since this structure is inexpensive and further the ITO is not connected directly to any organic substance, good results can be obtained from the viewpoint of the above-mentioned adhesiveness improvement also. Thus, an element in which the generation of dark spots and others are restrained can be formed.

In JP-A-9-63771 (hereinafter referred to as the document 7), a metal oxide having a larger work function value than that of ITO (such as RuO, MoO or VO) is formed into a thickness of 5 to 30 nm between ITO which is an anode and a hole transporting layer to reduce the energy barrier between the anode and the hole transporting layer, thereby making an attempt for improving the luminous efficiency.

JP-A-08-031573 (hereinafter referred to as the document 8) discloses a structure in which a part or the whole of an anode is made of a carbon thin film.

Besides these, JP-A-03-210791, 03-262170 and 06-119973 disclose the use of a P-type semiconductor as a hole transporting material.

[3] Buffer layer in which an insulator thin film layer is formed between an anode and an organic substance layer

USP No. 5853905 (hereinafter referred to as the document 9) describes a suggestion for an improvement in the adhesiveness between a transparent electrode and an organic substance, or a suggestion of a new element structure in which an electric charge barrier is positively formed and a tunnel injecting mechanism is used.

JP-A-08-288069 (hereinafter referred to as the document 10) discloses a structure in which a nitride such as aluminum nitride is formed into a thin film of about 50 Å thickness between an anode and an organic substance layer in order to avoid the generation of a leakage generated when the element having the structure is continuously driven.

[4] Buffer layer obtained by subjecting the surface of an anode to reverse sputtering in advance

JP-A-11-126689 (hereinafter referred to as the document 11) recognizes that a cause for generating a leakage current or dark spots is unevenness in the surface of an anode, and suggests an anode surface treatment based on reverse sputtering in order to remove the unevenness.

Disclose of the Invention

Problems to be Solved by the Invention

In the prior arts described in the items [1] to [3] in "(2) Lamination of the buffer layer on the anode" of above "B. [Examples of documents in the prior art]", the objects thereof are: improvements in joint properties between an anode and an organic substance layer, such as an improvement in the adhesiveness therebetween; an improvement in the property of injecting holes from the anode to the organic substance layer; and others.

However, as described in "(3) Defective surface layer on the anode" and (4) of above "A. [Technical Background] ", various inconveniences are generated because of the existence of a defective surface layer, which is primarily present on the surface of a transparent electrode made of ITO or the like. It is feared that, for example, due to the existence of a defective surface layer, a rise in the driving voltage at the time of driving an element continuously becomes large to result in a phenomenon that the lifespan becomes short. Furthermore, it becomes difficult to keep the heat resistance. It is supposed that this point becomes a problem, in particular, when the element is applied to various on-vehicle display devices or the like. Furthermore, in particular, in the case of highly minute CCM panels, the shrinkage of luminous pixels which results from the generation of a defective surface layer and enlargement thereof becomes a problem. This would become remarkable particularly in a high temperature environment. There has not been known any

example in which measures are taken while attention is paid to such points.

In the item [4] of the above "(2) Lamination of the buffer layer on the anode", an anode surface treatment based on reverse sputtering is suggested; however, the treatment would be insufficient for the following reason. Since an inorganic compound is not laminated after the reverse sputtering, the buffer layer is probably contaminated in vacuum so that the resultant surface is returned into an original surface state by action of water content or the like, which is present in the vacuum tank also; thus, the advantageous effect would be insufficient.

In light of these problems, the present invention has been made. Objects thereof are as follows:

(1) One of the objects is to remove a defective surface layer present in the surface of an anode of a CCM substrate, and protect the anode surface.

(2) The other object is to stabilize the performance of an organic EL element, and stabilize that of a CCM panel accordingly, specifically prevent a rise in the driving voltage, maintain the luminous uniformity, and improve the heat resistance.

Means for Solving the Problems

In order to solve the above-mentioned problems, the present invention suggests a new structure, which is different from the prior arts, in which a defective surface layer is removed and then a lamination of an inorganic compound is attained. This lamination of the inorganic compound produces an effect, which the prior arts do not give, that the generation of a new defective surface layer is prevented.

The existence of the surface protecting layer of the present invention makes it possible to prevent the generation of a defective surface layer on an anode. For example, in the state that a barrier layer for separating a cathode is formed on an anode of a CCM substrate for a full color panel, the product can be stored or moved without considering contamination or others especially. When a panel is produced (when a film of an organic EL is formed), it is sufficient therefor that a process which follows a conventional given production process is carried out.

Specifically, the present invention adopts the following structures:

In order to solve the above-mentioned problems, the invention is an electrode substrate comprising a substrate, an electrode comprising an In atom containing compound, and a fluorescence converting layer which is a layer positioned between the electrode and the substrate in order to convert the wavelength of light radiated into this layer, characterized in that a surface protecting layer comprising an inorganic compound is formed on a surface of the electrode which is a surface opposite to an electrode surface facing the fluorescence converting layer. Such a structure makes it possible to prevent the generation of a defective surface layer. Specifically, it is possible to prevent effectively the generation of a defective surface layer by contact with the atmosphere or the like.

The invention is also characterized in that the constituting material of the substrate and/or the electrode is a transparent material. The use of such a transparent material gives an electrode substrate which can be used as displaying means.

The invention is also characterized in that the electrode surface of the electrode substrate is subjected to reverse sputtering treatment. Such a structure makes it possible to decrease a defective surface layer on the electrode surface effectively, thereby making the electrode surface and the inside thereof homogeneous.

The invention is also characterized in that the reverse sputtering treatment is a reverse sputtering treatment based on inductively coupled RF plasma supported magnetron sputtering. According to such a structure, an electric discharge gas ion is easily obtained which has a kinetic energy that is just suitable for removal of a defective surface layer on the anode surface. For this reason, any defective surface layer can be removed without damaging the electrode.

The invention is also characterized in that the inorganic compound which constitutes the surface protecting layer is any one of an oxide, a nitride, a complex oxide, a sulfide, and a fluoride of at least one selected from Ba, Ca, Sr, Yb, Al, Ga, In, Li, Na, K, Cd, Mg, Si, Ta, Ge, Sb, Zn, Cs, Eu, Y, Ce, W, Zr, La, Sc, Rb, Lu, Ti, Cr, Ho, Cu, Er, Sm, W, Co, Se, Hf, Tm, Fe and Nb. Such a structure makes it possible to form a dense surface protecting layer on the electrode surface.

The invention is also characterized in that the surface protecting layer is formed by sputtering. Such a structure makes it possible to form a defective surface layer while removing any defective surface layer on the electrode.

The invention is also characterized in that the surface protecting layer is formed by sputtering using inductively coupled RF plasma supported magnetron sputtering. Such a structure makes it possible to form a surface protecting layer effectively.

The invention is also characterized in that the film thickness of the surface protecting layer is a value within the range of 5 to 100 Å. Such a structure makes it possible to prevent the regeneration of a defective surface layer and further ensure a given light transmissibility.

The invention is also characterized in that the electrode comprises indium tin oxide (ITO) or indium zinc oxide (IZO). Such a structure makes it possible to yield an excellent light transmissibility.

The invention is also characterized in that the electrode is an amorphous oxide. Such a structure makes it possible to give an excellent etchable property. ITO is usually crystalline; however, TTO can be made amorphous by a method of rendering the atmosphere when ITO is formed into a film a water atmosphere, a method of doping ITO with a trace element, or some other method.

The invention is also characterized by comprising a driving element for driving the electrode. In recent years, there has widely been used, in particular, a liquid crystal display device or organic EL display device in which a thin film transistor (TFT) is provided to each pixel to improve display performance. Thus, an electrode substrate in which a driving element such as a TFT is beforehand formed is provided, thereby making easy the production of a TFT system liquid crystal display device or organic EL display device as described above.

The following are inventions concerned with an electrode substrate producing method.

In order to solve the above-mentioned problems, the invention is a method for producing an electrode substrate, the electrode substrate comprising a substrate, an electrode comprising an In atom containing compound, and a fluorescence converting layer which is a layer positioned between the electrode and the substrate in order to convert the wavelength of light radiated into this layer, characterized by comprising the step of forming the fluorescence converting layer on the substrate, the step of forming the electrode on the formed fluorescence converting layer, and the step of subjecting the surface of the formed electrode to reverse sputtering treatment, in which in the step of subjecting the electrode surface to the reverse sputtering treatment, a surface protecting layer comprising an inorganic compound is formed after or when the reverse sputtering treatment is carried out.

Such a structure makes it possible to produce an electrode substrate in which a defective surface layer on an electrode is decreased.

The surface protecting layer comprising the inorganic compound makes it possible to keep a state that any defective surface layer is removed and prevent the regeneration of a defective surface layer effectively.

The invention is also characterized in that the reverse sputtering treatment is carried out using inductively coupled RF plasma supported magnetron sputtering. According to such a structure, an electric discharge gas ion is easily obtained which has a kinetic energy that is just suitable for removal of a defective surface layer on the anode surface. For this reason, any defective surface layer can be removed without damaging the electrode.

The invention is also characterized in that in the reverse sputtering treatment, a high frequency wave having an electric power of 50 to 200 W and a frequency of 13. 56 to 100 MHz is applied to a helical coil for the inductively coupled RF plasma supported magnetron sputtering, and a high frequency wave having an electric power of 200 to 500 W and a frequency of 13.56 to 100 MHz is applied to a cathode for the inductively coupled RF plasma supported magnetron sputtering, thereby causing plasma discharge; and the intensity of a magnetron magnetic field for the inductively coupled RF plasma supported magnetron sputtering is set to a value within the range of 200 to 300 gausses.

Such a structure makes it possible to remove any defective surface layer on the electrode surface more effectively.

The invention which is related to an electrode substrate and is particularly specified by values measured by XPS is as follows.

In order to solve the above-mentioned problems, the invention is an electrode substrate comprising a substrate, an electrode comprising an In atom containing compound, and a fluorescence converting layer which is a layer positioned between the electrode and the substrate in order to convert the wavelength of light radiated into this layer, characterized in that a surface protecting layer comprising an inorganic compound is formed on a surface of the electrode which is a surface opposite to an electrode surface facing the fluorescence converting layer, wherein results of the electrode surface measured by X-ray photoelectron spectroscopy are as follows:

The invention is also characterized in that when the full-width half-maximum of a peak of the $3d_{5/2}$ orbital spectrum of the In atoms measured in the electrode surface by X-ray photoelectron spectroscopy is represented by $[In3d_{5/2}]_h$ and the full-width half-maximum of a peak of the $3d_{5/2}$ orbital spectrum of the In atoms measured in the inside of the electrode by X-ray photoelectron spectroscopy is represented by $[In3d_{5/2}]_n$,
the value of $([In3d_{5/2}]_h/[In3d_{5/2}]_n)$, which is the ratio between the respective full-width half-maximums, is within the range of 0.9 to 1.2.

Such a structure makes it possible to make an electrode substrate in which no defective surface layer is present on an electrode by limiting the ratio between the full-width half-maximum of the $In3d_{5/2}$ orbital spectrum peak in the "inside" of the electrode and the full-width half-maximum in the "surface" of the electrode into a value within the given range.

In the invention of the present application, the wording "measured in the surface" means the following: "measured in at least one portion or one point in the surface".

The invention is also an electrode substrate comprising a substrate, an electrode comprising an In atom containing compound, and a fluorescence converting layer which is a layer positioned between the electrode and the substrate in order to convert the wavelength of light radiated into this layer, characterized in that a surface protecting layer comprising an inorganic compound is formed on a surface of the electrode which is a surface opposite to an electrode surface facing the fluorescence converting layer, wherein results measured by X-ray photoelectron spectroscopy are measured values as described in the following:

the invention is also characterized in that the value of the peak of the $3d_{5/2}$ orbital spectrum of the In atoms measured in the electrode by X-ray photoelectron spectroscopy is represented by In peak, the value of the peak of the $3d_{5/2}$ orbital spectrum of Sn atoms measured in the electrode by X-ray photoelectron spectroscopy is represented by Sn peak, the ratio between the respective peaks measured in the surface of the electrode is represented by (In peak/Sn peak)h, and the ratio between the respective peaks measured inside the electrode is represented by (In peak/Sn peak) n, the following is satisfied:

$$((\text{Sn peak}/\text{In peak})h/(\text{Sn peak}/\text{In peak})n) < 1.5.$$

Such a structure makes it possible to make an electrode substrate in which no defective surface layer is present on an electrode by measuring, inside and outside the electrode, the ratio between the peak value of the In atoms and the peak value of the Sn atoms and then limiting the resultant inside ratio and outside ratio within the given range.
In the same manner as in the above-mentioned inventions, the wording "measured in the surface" means the following: "measured in at least one portion or one point in the surface".

Advantageous Effects of the Invention

As described above, according to the electrode substrate of the invention, the electric stability thereof is improved since an electrode in which a defective surface layer is decreased is used. Accordingly, when this electrode substrate is used as, for example, ananodeofanorganicELelement, an advantageous effect that the lifespan of the element can be made long can be produced. Furthermore, an advantageous effect that a rise in the driving voltage of this organic EL element can be restrained is produced. Additionally, the heat resistance of this organic EL element can be improved.
According to the invention, an electrode substrate fitted to, for example, the production of a display device of a TFT system or some other system can be provided since a driving element for driving an electrode on the electrode substrate is formed.
When the electrode substrate of the invention is used as an electrode of an organic EL element to make an organic EL display device, luminous unevenness or a scattering in luminescence is reduced so that an organic EL display device having an improved image quality can be obtained. Furthermore, about the image quality of the organic EL display device, the reliability thereof over time can be improved.
According to the electrode substrate producing method of the invention, an electrode substrate which produces advantageous effects as described above can be produced.

Brief Description of the Drawings

Fig. 1 is a schematic sectional view illustrating a structure of a preferred organic EL display device of the invention.
Fig. 2 is a schematic graph showing spectra in the case of examining an In containing compound by XPS.
Fig. 3 is a schematic sectional view illustrating a structure of an organic EL display device according to embodiment 2.
Fig. 4 is a schematic sectional view of a CCM type organic EL display device in the prior art.

Best Mode for Carrying Out the Invention

Preferred embodiments of the invention will be described hereinafter on the basis of the drawings.

<u>A. Basic structure</u>

In the present embodiment, suggested is a structure in which an inorganic compound layer is laminated on an anode of a color converting (CCM) substrate and an organic substance layer is laminated thereon. A schematic view illustrating a section showing such a structure of an organic EL display device 100 is shown in Fig. 1.
As illustrated in this figure, a characteristic point of the embodiment is that a surface protecting layer 102 made of an inorganic compound or organic compound is formed on an anode 16. An organic substance layer 18 is laminated on this surface protecting layer 102.
The organic substance layer 18 is also called a light emitting layer since the layer is a part for fulfilling light

emission. The layer is also called an organic compound layer since organic substance is a compound inmany cases. This organic substance layer 18 has at least a recombination region and a light emitting region. This organic substance layer 18 is also called an organic EL element layer.

About the organic substance layer 18, for example, a hole injecting layer, an electron injecting layer, an organic semiconductor layer, an electron barrier layer, an adhesion improving layer, and the like may be optionally formed besides the organic substance layer 18 (the light emitting layer). In this case, plural layers including the hole injecting layer and/or the other layer(s) are generally called the organic substance layer 18. A cathode 20 is formed on the organic substance layer 18 composed of these plural layers.

In the present embodiment, the organic EL display device 100 is described as an example. However, this organic EL display device corresponds to one of the "light emitting device" in the claims. An organic EL itself is primarily a light emitting element; therefore, the EL constitutes a light emitting device having a function of emitting light. In the embodiment, the organic EL display device 100 is described as one example of this light emitting device. However, the "light emitting device" of the invention is not limited to any organic EL display device.

Typical structural examples (variations) of the organic EL display device 100 described in the embodiment are listed up. Of course, the device structure is not limited thereto.

Basic layer structures of the organic EL display device 100 are as follows:

substrate/color converting film (CCM layer) /passivation film/organic EL element

The organic EL element 122 herein has the following variations:

(1) transparent electrode (anode)/surface protecting layer/light emitting layer/electrode (cathode)
(2) transparent electrode (anode)/surface protecting layer/hole injecting layer/light emitting layer/electrode (cathode)
(3) transparent electrode (anode)/surface protecting layer/light emitting layer/electron injecting layer/electrode (cathode)
(4) transparent electrode (anode)/surface protecting layer/hole injecting layer/light emitting layer/electron injecting layer/electrode (cathode)
(5) anode/surface protecting layer/organic semiconductor layer/light emitting layer/cathode
(6)anode/surface protecting layer/organicsemiconductor layer/electron barrier layer/light emitting layer/cathode
(7) anode/surface protecting layer/hole injecting layer/light emitting layer/adhesion improving layer/cathode

Structures as described above can be listed up. Usually, among these, the structure (4) is preferably used.

A characteristic in the present embodiment is the surface protecting layer 102 contained in the organic EL element 122.

B. Re: Defective surface layer of a transparent electrode made of ITO or the like

A defective surface layer of an electrode is described herein.

As described in the (4) of "A. Background Technique" in Background Art already, the surface of a transparent electrode made of ITO or the like is damaged by excessive washing in the step of washing, residues resulting from etching for patterning, or the like. What is called a defective surface layer as described below is generated by adsorption of water on the surface, precipitation of trace impurity atoms contained in the bulk, or other factors. There has not yet been known any example in which attention is paid to this problem of the defective surface layer so as to make an attempt for improvement. As a result, in conventional organic EL elements, an organic substance is laminated on their anode in the state that the anode is accompanied with a defective surface layer. Thus, it appears that element performances which should be originally obtained cannot be ensured in many cases because of a decline in charge-injectable property in the interface, or other factors.

(1) Defective surface layer

Examples of the defective surface layer which is the present embodiment include layers satisfying any one of the following requirements:

[1] Precipitation of Sn, which is a dopant, onto the surface. In the case of IZO, deletion of Zn is given as an example.
[2] Deletion or omission of oxidized pores, which are dopants, in the surface (that is, excessive oxygen atoms).
[3] Adsorption of water content onto the surface.
[4] Precipitation of trace impurities (nitrogen and so forth) contained in the bulk onto the surface.

By the presence of such a defective surface layer, the following are observed: a fall in the electroconductivity (hole injectable property); a fall in the adhesive property of an organic substance laminated thereon; diffusion of impurities in the defective surface layer into the organic substance layer; and the like.

It has been made evident that the following problems are caused by the presence of such a defective surface layer.

[1] A rise in the voltage when the EL element is continuously driven at a constant current is large, so that the lifespan thereof becomes short.

[2] The adhesive property onto the organic substance laminated on the defective surface layer falls. As a result, when the element is driven at high temperature, the light emission becomes uneven. After the element is stored at high temperature, the light emission becomes uneven as well. Similarly, at high temperature, the current injectable property and the luminous efficiency decline, or others are caused. In short, what is called the heat resistance declines.

(2) Method for detecting a defective surface layer

The layer is analytically detected by X-ray photoelectron spectroscopy (XPS).

[1] The size of a peak of the spectrum $In3d_{5/2}$ (bonding energy: 444.4 eV) of the In atoms (hereinafter referred to as the In peak), which reflects the situation of the vicinity of the In atoms, and the size of a peak of Sn $3d_{5/2}$ (bonding energy: 486.2 eV) of the Sn atoms (hereinafter referred to as the Sn peak) are each obtained. The presence of a defective surface layer is detected on the basis of the fact that the ratio therebetween (Sn peak/In peak) becomes larger near the surface than in the inside of the electrode (bulk). About the calculation of the In peak and Sn peak, actually the obtained values are amended with the sensitivity based on the atoms, so as to give final values.

The ratio of Sn peak/In peak is roughly a value in the range from 0.1 to 0.2. It appears that Sn precipitates in the surface if the value thereof in the surface is 1.5 times or larger than that in the bulk. In this case, the presence of a defective surface layer is acknowledged. In other words, when the value of Sn peak/In peak in the surface of the electrode is represented by $(\text{Sn peak/In peak})_h$, and the value of Sn peak/In peak inside the electrode is represented by $(\text{Sn peak/In peak})_n$, the presence of a defective surface layer is acknowledged in the case that the following is satisfied: $(\text{Sn peak/In peak})_h/(\text{Sn peak/In peak})_n \geq 1.5$. Conversely, when an electrode satisfying (Sn peak/In peak) h/ (Sn peak/In peak)n < 1.5 is produced, it can be considered that a defective surface layer is not virtually present. XPS measurement in the surface of any electrode is generally performed in one part or one point of the surface. Thus, the above-mentioned measurement also means measurement in one part or one point of the surface of an electrode.

[2] When the full-width half-maximum of a peak of the spectrum $In3d_{5/2}$ of the In atoms, which reflects the situation of the vicinity of the In atoms, is evidently larger in the surface than in the bulk, the atomic composition of the surface is different. Thus, a defective surface layer is generated. An example thereof will be described hereinafter with reference of a schematic view of Fig. 2. This schematic view is a schematic view in which spectrum intensity (arbitrary unit) is taken on its vertical axis and bonding energy is taken on its transverse axis.

For example, an electrode is subjected to ordinary washing with an organic solvent, and then subjected to UV washing. The electrode (formed on a substrate) at the stage when the UV washing is ended is promptly put into a measuring chamber for XPS, and measured or observed. As a result, the above-mentioned full-width half-maximum is 1.7 eV (shown by A in Fig. 2). This is the peak full-width half-maximum of $In3d_{5/2}$ in the surface. This is sputtered with an argon ion gun for 30 seconds, and is eroded off by about 50 Å. The resultant re-surface is observed and measured. As a result, the full-width half-maximum is 1.2 eV (shown by B in Fig. 2). The latter full-width half-maximum would be the full-width half-maximum of ITO of the bulk.

When the full-width half-maximum of a peak of $In3d_{5/2}$ in the surface is represented by $[In3d_{5/2}]_h$ and the full-width half-maximum of a peak of $In3d_{5/2}$ in the bulk (inside) is represented by $[In3d_{5/2}]_n$, the atomic composition of the electrode surface is different from that of the inside in the case that the value of $[In3d_{5/2}]_h/[In3d_{5/2}]_n$, which is the ratio between the two, is not within the range of 0.9 to 1.2. Thus, it is acknowledged that a defective surface layer is present. When this value is calculated using, for instance, the above-mentioned example, a value of 1.7/1.2 = 1.42 is obtained. Since this is not within the range of 0.9 to 1.2, it is judged that a defective surface layer is present.

About an electrode in which $SiO_2$ is formed into a film on an ITO electrode, which is different from the example described in this [2], the electrode is washed in the same manner as described above and the full-width half-maximum of $In3d_{5/2}$ of the surface thereof is observed and measured. As a result, the value is 1.2 eV. The value is equal to the value of the bulk of ITO. It is understood from this result that any defective surface layer is removed on the surface of the substrate on which the film of $SiO_2$ is formed. This is because the value of $[In3d_{5/2}]_h/[In3d_{5/2}]_n$ is 1.0 and is within the range of 0.9 to 1.2. This formation of $SiO_2$ is carried out, using helical sputtering. In other words, in this film-forming step, sputtering is used to remove any defective surface layer and simultaneously form $SiO_2$ into

a film which is a surface protecting layer on the electrode surface.

For reference, inductively coupled RF plasma supported magnetron sputtering is called "helical sputtering".

It has been known that in the case that the electric discharge gas flow rate when the film is formed by the helical sputtering is changed, the full-width half-maximum of the $In3d_{5/2}$ peak in the substrate surface on which the film of $SiO_2$ is formed changes. Specifically, it has been made evident that when the electric discharge gas flow rate is made large, the full-width half-maximum becomes narrow so that any defective surface layer tends to be further removed.

The present inventors have found out from the above matters that any defective surface layer on the surface of an ITO electrode can be removed by sputtering effect of an electric discharge gas.

A characteristic of the invention is that a surface protecting layer comprising an inorganic compound such as $SiO_2$ is formed on an electrode by sputtering. By this sputtering, any defective surface layer can be removed from the electrode surface and further the protecting layer for protecting the surface can be formed.

[3] The film thickness of the surface protecting layer can be selected from film thicknesses of about 5 to 100 Å. The film thickness is preferably from 10 to 50 Å, more preferably from 20 to 40 Å.

In general, if the film thickness of the formed film is from 5 to 20 Å, the film has an island structure so that an even interface is not easily formed. However, when the film thickness is 5 Å or more, the reproducibility of the advantageous effects is obtained. The inventors have recognized from observation with a transmission electron microscope that: when the film thickness is at least 20 Å, the formed film is even or homogeneous; and such a sputtering film, in particular, such a helical sputtering film is a stable and dense film.

On the other hand, if the film thickness is too large (about 100 Å or more), injection barrier between the anode and the organic substance layer becomes a problem since inorganic compounds, such as $SiO_2$, are primarily insulators and have a low electroconductivity in many cases. Thus, the voltage for the element unfavorably becomes high.

C. Structure of each of the layers

Each of the layers which constitute the organic EL display device 100 will be described hereinafter.

As described above, the organic EL display device 100 has the following structure:

substrate/color converting film (CCM layer)/passivation layer/organic EL element

About an example in which the organic EL element 122 has a structure of "transparent electrode (anode)/ surface protecting layer/hole injecting layer/light emitting layer/electron injecting layer/electrode (cathode)", each of the layers will be described hereinafter.

(1) Re: Surface protecting layer 102-inorganic compound layer

First, the surface protecting layer 102102, which comprises an inorganic compound and is a point of the invention, is described.

This surface protecting layer 102 is preferably made of an oxide, nitride, complex oxide, sulfide or fluoride of a metal such as Ba, Ca, Sr, Yb, Al, Ga, In, Li, Na, K, Cd, Mg, Si, Ta, Ge, Sb, Zn, Cs, Eu, Y, Ce, W, Zr, La, Sc, Rb, Lu, Ti, Cr, Ho, Cu, Er, Sm, W, Co, Se, Hf, Tm, Fe or Nb. Of these examples, silicon oxide SiOx (where x represents an atomic ratio) is effective.

More preferred and specific examples thereof include metal oxides or metal nitrides such as LiOx, LiNx, NaOx, KOx, RbOx, CsOx, BeOx, MgOx, MgNx, CaOx, CaNx, SrOx, BaOx, ScOx, YOx, YNx, LaOx, LaNx, CeOx, PrOx, NdOx, SmOx, EuOx, GdOx, TbOx, DyOx, HoOx, ErOx, TmOx, YbOx, LuOx, TiOx, TiNx, ZrOx, ZrNx, HfOx, HfNx, ThOx, VOx, VNx, NbOx, NbNx, TaOx, TaNx, CrOx, CrNx, MoOx, MoNx, WOx, WNx, MnOx, ReOx, FeOx, FeNx, RuOx, OsOx, CoOx, RhOx, IrOx, NiOx, PdOx, PtOx, CuOx, CuNx, AgOx, AuOx, ZnOx, CdOx, HgOx, BOx, BNx, AlOx, AlNx, GaOx, GaNx, InOx, SiNx, GcOx, SnOx, PbOx, POx, PNx, AsOx, SbOx, ScOx, and TeOx.

Furthermore, the following metal complex oxides may be used: $LiAlO_2$, $Li_2SiO_3$, $Li_2TiO_3$, $Na_2Al_{22}O_{34}$, $NaFeO_2$, $Na_4SiO_4$, $K_2SiO_3$, $K_2TiO_3$, $K_2WO_4$, $Rb_2CrO_4$, $Cs_2CrO_4$, $MgAl_2O_4$, $MgFe_2O_4$, $MgTiO_3$, $CaTiO_3$, $CaWO_4$, $CaZrO_3$, $SrFe_{12}O_{19}$, $SrTiO_3$, $SrZrO_3$, $BaAl_2O_4$, $BaFe_{12}O_{19}$, $BaTiO_3$, $Y_3Al_5O_{12}$, $Y_3Fe_5O_{12}$, $LaFeO_3$, $La_3Fe_5O_{12}$, $La_2Ti_2O_7$, $CeSnO_4$, $CeTiO_4$, $SM_3Fe_5O_{12}$, $EuFeO_3$, $Eu_3Fe_5O_{12}$, $GdFeO_3$, $Gd_3Fe_5O_{12}$, $DyFeO_3$, $Dy_3Fe_5O_{12}$, $HoFeO_3$, $HO_3Fe_5O_{12}$, $ErFeO_3$, $Er_3Fe_5O_{12}$, $Tm_3Fe_5O_{12}$, $LuFeO_3$, $Lu_3Fe_5O_{12}$, $NiTiO_3$, $Al_2TiO_3$, $FeTiO_3$, $BaZrO_3$, $LiZrO_3$, $MgZrO_3$, $HfTiO_4$, $NH_4VO_3$, $AgVO_3$, $LiVO_3$, $BaNb_2O_6$, $NaNbO_3$, $SrNb_2O_6$, $KTaO_3$, $NaTaO_3$, $SrTa_2O_6$, $CuCr_2O_4$, $Ag_2CrO_4$, $BaCrO_4$, $K_2MoO_4$, $Na_2MoO_4$, $NiMoO_4$, $BaWO_4$, $Na_2WO_4$, $SrWO_4$, $MnCr_2O_4$, $MnFe_2O_4$, $MnTiO_3$, $MnWO_4$, $CoFe_2O_4$, $ZnFe_2O_4$, $FeWO_4$, $CoMoO_4$, $CoTiO_3$, $CoWO_4$, $NiFe_2O_4$, $NiWO_4$, $CuFe_2O_4$, $CuMoO_4$, $CuTiO_3$, $CuWO_4$, $Ag_2MoO_4$, $Ag_2WO_4$, $ZnAl_2O_4$, $ZnMoO_4$, $ZnWO_3$, $CdSnO_3$, $CdTiO_3$, $CdMoO_4$, $CdWO_4$, $NaAlO_2$, $MgAl_2O_4$, $SrAl_2O_4$, $Gd_3Ga_5O_{12}$, $InFeO_3$,

$MgIn_2O_4$, $Al_2TiO_5$, $FeTiO_3$, $MgTiO_3$, $Na_2SiO_3$, $CaSiO_3$, $ZrSiO_4$, $K_2GeO_3$, $Li_2GeO_3$, $Na_2GeO_3$, $Bi_2Sn_3O_9$, $MgSnO_3$, $SrSnO_3$, $PbSiO_3$, $PbMoO_4$, $FbTiO_3$, $SnO_2$-$Sb_2O_3$, $CuScO_4$, $Na_2SeO_3$, $ZnSeO_3$, $K_2TeO_3$, $K_2TeO_4$, $Na_2TeO_3$, and $Na_2TeO_4$.

Preferred materials also include sulfides such as FeS, $Al_2S_3$, MgS and ZnS, fluorides such as LiF, $MgF_2$ and $SmF_3$, chlorides such as HgCl, $FeCl_2$ and $CrCl_3$, bromides such as AgBr, CuBr and $MnBr_2$, iodides such as $PbI_2$, CuI and $FeI_2$, and metal oxides such as SiAlON.

Among these, preferred are oxides and particularly preferred are stable oxides having a standard formation Gibbs energy of -520 $kJmol^{-1}$ or more. Examples thereof include $SiO_2$ (-855 $kJmol^{-1}$), $GeO_2$ (-497 $kJmol^{-1}$), $CeO_2$ (-1025 $kJmol^{-1}$), and $Al_2O_3$ (-1581.9 $kJmol^{-1}$).

Preferred other compounds include AlN, SiC and CaS, which are each a stable compound.

The following will describe processes for forming the surface protecting layer 102 on an electrode.

Outline of processes for forming the film

Process 1: A substrate with an anode (transparent electrode) is subjected to wet washing. This is identical with substrate-washing which is performed before a film of an ordinary element is formed. Specifically, effective is a combination of ultrasonic washing using an organic solvent such as 2 propanol with rinse washing by pure water. It is also preferred to perform ultrasonic washing using a neutral detergent or the like which is suitable for the degree of stains on the anode surface.

Process 2: A film of an inorganic oxide is formed by sputtering such as helical sputtering. The reason why the inorganic compound is formed into the film by sputtering is as follows:

· First, oxides or nitrides generally require high temperature for evaporation (or vapor deposition) thereof. Thus, it is difficult to evaporate the compounds in a resistance heating manner.

· Furthermore, the inorganic compound can be formed into a film by electron beam evaporation. However, this method, unlike sputtering, does not have an effect of changing the nature of a defective surface layer of ITO.

· The reason why sputtering has an effect of changing the nature of a defective surface layer of ITO appears to be as follows: electric discharge gas ions generated by plasma are accelerated by the electric field of self-bias generated by the plasma so that the defective surface layer is beaten, whereby sputtering cleaning (what is called reverse sputtering) is caused.

· Among sputtering methods, helical sputtering is particularly preferred. The reason therefor is as follows: in helical sputtering, the distance between a target and a substrate is generally made large; therefore, in ordinary sputtering, an excessive energy is given to a substrate so that damage is conversely given to the substrate; however, experiments have demonstrated that it is a kinetic energy (about 0.1 to 1 eV) which is just suitable for removal of a defective surface layer of an anode in helical sputtering.

Specific examples of processes for forming the film

Step 1: It is checked that before the introduction of gas into a vacuum chamber the vacuum degree is within the first half of the range from $10^{-2}$ to $10^{-3}$ Pa.

Step 2: An electric discharge gas such as Ar is introduced into the vacuum chamber. The vacuum degree at this time is from about $1 \times 10^0$ Pa to $1 \times 10^{-2}$ Pa. Preferably, the vacuum degree is, for example, from 0.3 to 1.0 Pa so as not to be made very low. This is because the effect of removing a defective surface layer is reduced at a low pressure. The kind of the electric discharge gas is selected from rare gases such as Ar, Xe and Kr. Ar is preferred from the viewpoint of costs.

Step 3: Successively, a high frequency wave having a power of 50 to 200 W and a frequency of 13.56 to 100 MHz is applied to a helical coil (coil for inductive coupling), and that having a power of 200 to 500 W and a frequency of 13.56 to 100 MHz is applied to a cathode to cause plasma discharge. Preferably, the intensity of the magnetron magnetic field at this time is roughly from 200 to 300 gausses.

Step 4: The surface of a target is cleaned by sufficient pre-sputtering. The cleaning is preferably performed for at shortest 5 minutes or more, in particular, 10 minutes or more at the first time after the exchange of the target.

Step 5: Next, a main shutter of the sputtering machine is opened so as to form the inorganic compound into a film until the film has a given thickness (5 to 100 Å).

(2) Substrate 12

The substrate used in the present embodiment is preferably made of a transparent material having a rigidity sufficient for supporting a color display device. In the embodiment, the substrate is arranged, thereby reinforcing a col

or display device to make the mechanical intensities thereof, such as the impact resistance, high.

Specific examples of the material include glass plates, ceramic plates, and plastic plates (polycarbonate, acryl, vinyl chloride, polyethylene terephthalate, polyimide and polyester resins, and other resins).

(3) CCM layer 14

The CCM 14 (also called the color converting layer) has a function of absorbing light emitted from the organic EL element 122 and emitting longer-wavelength fluorescence. For example, blue light is converted to green light or red light. It may contain a color filter besides the CCM layer 14 in order to make the color reproducibility good.

Each portion of the CCM layer 14 is preferably arranged correspondingly to each luminous area of the organic EL element 122, for example, each position where the anode 16 and the cathode 20 cross each other. The anode 16 and the cathode 20 are arranged in a stripe form on the face for display, and further the two are formed along directions that the two cross at right angles. The organic substance layer 18 present at positions where the anode 16 and the cathode 20 overlap (at positions where the two cross each other) on the plane emits light. This overlapping positions (crossing positions) each correspond to "one pixel" on the display plane.

According to such a structure, when the organic substance layer 18 (organic EL light emitting layer) at the crossing portions of the anode 16 and the cathode 20 emits light, the light is received by each section of the CCM layer 14 so that luminescence having a different color (wavelength) can be taken out.

In this case, particularly preferred is a structure in which the organic EL element 122 emits blue light and further the light can be converted to green light and red light by the CCM layer 14 since the three primary colors of blue, green and red can be obtained and a full color display can be attained even if the organic EL element 122 is made of the layer 18 consisting of an organic substance of one kind.

(3-1) Material

The material of the CCM layer 14 is not particularly limited. For example, the layer is made of a fluorescent colorant, or a fluorescent colorant and a binder resin. A typical example of the CCM layer 14 made of the fluorescent and the binder resin is a solid-state layer in which the fluorescent is dissolved or dispersed in a pigment resin and/or the binder resin.

The fluorescent colorant is specifically described herein. Examples of the fluorescent colorant for converting violet luminescence from near ultraviolet light in the organic EL element 122 to blue luminescence include stylbene colorants such as 1,4-bis(2-methylstyryl)benzene (Bis-MBS), and trans-4,4'-diphenylstylbene (DPS), and coumalin colorants such as 7-hydroxy-4-methylcoumalin (coumalin 4).

About the fluorescent colorant in the case that blue light, bluish green or white luminescence in the organic EL element 122 is converted to green luminescence, examples thereof include coumalin colorants such as 2,3,5,6-1H,4H-tetrahydro-8-trifluoromethylquinolidino(9,9a, 1-gh)coumalin (coumalin 153), 3-(2'-benzothiazolyl)-7-diethylaminocoumalin (coumalin 6) and 3-(2'-benzimidazolyl)-7-N,N-diethylaminacoumalin (coumalin 7), a basic yellow 51, which is a different coumalin colorant, and naphthalimide colorants such as solvent yellow 11 and solvent yellow 116.

About the fluorescent colorant in the case that luminescence in colors from blue to green, or white luminescence in the organic EL element 122 is converted to luminescence in any color from orange to red, examples thereof include cyanine colorants such as 4-dicyanomethylene-2-methyl-6-(p-dimethylaminostyryl)-4H pyran (DCM), pyridine colorants such as 1-ethyl-2-(4-(p-dimethylaminophenyl)-1,3-butadienyl)-pyridi um-perchlorate (pyridine 1), rhodamine colorants such as rhodamine B and rhodamine 6G, and oxazine colorants.

About various dyes (such as direct dyes, acidic dyes, basic dyes, and disperse dyes) also, ones that give fluorescence can each be selected as the fluorescent dye.

The following may also be used: a pigment-form product obtained by kneading a fluorescent colorant beforehand into a pigment resin such as polymethacrylate ester, polyvinyl chloride, vinyl chloride/vinyl acetate copolymer, alkyd resin, aromatic sulfonamideresin,urearesin,melamineresin,or benzoguanamine resin.

The binder resin is preferably a material having transparency (visible ray transmittance of 50% or more). Examples thereof include transparent resins (polymers) such as polymethyl methacrylate, polyacrylate, polycarbonate, polyvinyl alcohol, polyvinyl pyrrolidone, hydroxyethylcellulose, and carboxymethylcellulose.

In order to arrange the fluorescent medium so as to be two-dimensionally separated, a photosensitive resin to which photolithography can be applied can be selected. Examples thereof include optically curable resist materials having a reactive vinyl group, such as acrylic acid based, methacrylic acid based, polyvinyl cinnamate based, cyclic rubber based materials. In the case of using a printing process, a printing ink (medium) in which a transparent resin is used is selected. Examples thereof include a monomer, oligomer or polymer of polyvinyl chloride resin, melamine resin, phenol resin, alkyd resin, epoxy resin, polyurethane resin, polyester resin, maleic acid resin, or polyamide resin; and transparent resins such as polymethyl methacrylate, polyacrylate, polycarbonate, polyvinyl alcohol, polyvinyl pyrrolidone,

hydroxyethylcellulose, and carboxymethylcellulose.

(3-2) Forming method

In the case that the CCM layer 14 is made mainly of a fluorescent colorant, the layer is preferably formed by vacuum evaporation or sputtering through a mask capable of giving a desired pattern of the CCM layer 14.

In the case that the CCM layer 14 is made of a fluorescent colorant and a resin, the CCM layer 14 is preferably formed by mixing, dispersing or solubilizing the fluorescent colorant, the resin and an appropriate solvent to produce a liquid material, forming the liquid material into a film by spin coating, roll coating, casting or some other method, and then patterning the film into a desired pattern of the CCM layer 14 by photolithography, or patterning the fluorescent colorant and the resin into a desired pattern by screen printing or some other method.

(3-3) Thickness

The thickness of the CCM layer 14 is not particularly limited if the thickness causes the layer to receive (absorb) luminescence from the organic EL element 122 sufficiently and further causes no disturbance of the function of generating fluorescence. For example, the thickness is preferably from 10 nm to 1000 μm, more preferably from 0.1 to 500 μm, even more preferably from 5 to 100 μm.

The reason therefor is as follows: if the thickness of the CCM layer 14 is less than 10 μm, the mechanical strength falls or the layer may not be easily laminated; on the other hand, if the thickness of the CCM layer 14 is more than 1 mm, the light transmittance declines remarkably so that the light quantity which can be taken out may fall or the organic EL light emitting device may not be easily made thin.

<u>(4) Passivation film</u>

The passivation film is a film which makes it possible to block contact between the organic EL element 122 and volatile components from the CCM 14 film and any other resin film that are present below the passivation film. The material thereof is not particularly limited if the material is transparent for visible rays.

Specific examples of the material include transparent inorganic substances.

More specific examples thereof include transparent inorganic substances having a large work function, such as one selected from $SiO_2$, SiOx, $SiO_xN_y$, $Si_3N_4$, $Al_2O_3$, $AlO_xN_y$, $TiO_2$, $TiO_x$, ITO ($In_2O_3$-$SnO_2$), IZO ($In_2O_3$-ZnO), $SnO_2$, ZnO, indium copper (CuIn), gold, platinum, palladium and others, and any combination of two or more selected therefrom.

In the case that a transparent inorganic substance as described above is used, it is preferred that the CCM layer 14 is formed while the rate of the formation of the film is made small at low temperature (200°C or lower) not to deteriorate the CCM layer 14. Specifically, preferred is sputtering, vapor deposition, CVD, ion plating or the like.

The thickness of the passivation film, which depends on the minuteness of the organic EL element 122, can be selected from the range of 0.01 to 100 μm. The thickness is preferably 0.05 to 10 μm, more preferably 0.1 to 1 μm.

If the film thickness is less than 0.01 μm, the volatile components cannot be sufficiently blocked. If the film thickness is more than 100 μm, light from the organic EL element 122 diffuses so that desired incidence thereof into the CCM layer 14 is hindered. As a result, a drop in the perceptibility (color bleeding, color mixing or field angle dependency) may be caused.

<u>(5) Organic EL element 122</u>

In the organic EL display device 100 in the present embodiment, the above-mentioned inorganic compound layer (surface protecting layer 102) is formed on the anode 16 included in a CCM substrate 124, and further the organic substance layer 18 (called the organic compound layer also), which is a main material of the organic EL element 122, is laminated thereon. As this organic substance layer 18, a layer having at least a recombination area and a luminous area is used. The recombination area and the luminous area are present in a light emitting layer having a light emitting function in many cases. In the embodiment, therefore, only a light emitting layer may be used as the organic substance layer 18. If necessary, the following layers besides the light emitting layer may be incorporated into the organic substance layer 18: a hole injecting layer, an electron injecting layer, an organic semiconductor layer, an electron barrier layer, an adhesion improving layer, and so on. The cathode 20 is formed on the organic substance layer 18.

In the embodiment, the structure from the anode 16 (transparent electrode) to the cathode 20 is called the organic EL element 122. That is to say, briefly mentioning, the organic EL display device 100 is a device in which the organic EL element 122 is made on the substrate 12 made of glass or the like. In the embodiment, the following structure, which has already been described as an organic EL element, is used as an example to describe each of these layers from the next chapter.

Transparent electrode (anode)/surface protecting layer/hole injecting layer/light emitting layer/electron injecting layer/electrode (cathode)

Accordingly, explanation is herein made using, as an example, the structure in which the organic layer 18 is made of "hole injecting layer/light emitting layer/electron injecting layer". Of course, the organic layer 18 made of a mono-layered light emitting layer may be adopted.

(6) Anode 16 (transparent electrode)

Typical examples of the material of the anode 16 include ITO (indium tin oxide) and IZO, which each have a large work function (4 eV or more). The anode 16 can be produced by forming the electrode material into a thin film by vapor deposition, sputtering or some other method. In the case of taking out luminescence from the light emitting layer from the anode 16, it is preferred that the transmittance of the anode 16 for the luminescence is made larger than 10%. The sheet resistance of the anode 16 is preferably several hundreds of $\Omega/m^2$ or less. The film thickness of the anode 16, which depends on the material, is usually from 10 nm to 1 $\mu$m, preferably from 10 to 200 nm. In the embodiment, as the anode 16, a substrate electrode is used.

It is also preferred to adopt, as the material of the anode 16, an amorphous oxide and obtain a good etchable property. ITO is usually crystalline, but can be made amorphous by rendering the atmosphere at the time of making it into a film a water content atmosphere, or doping it with a trace element.

(7) Light emitting layer

In the light emitting layer in the embodiment, it is preferred to use, as the light emitting material (host material) thereof, a distyrylarylene compound represented by the following general formula (I):

[Chemical formula 1]

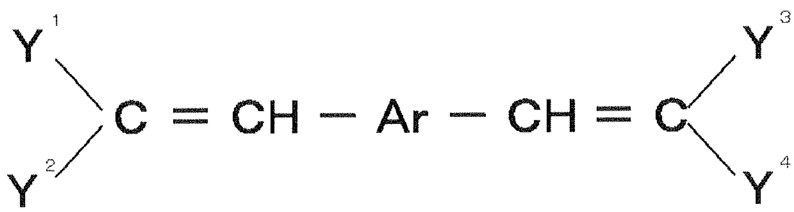

··· (I)

This compound is disclosed in, for example, JP-A-2-247278.

In the above general formula, Y1 and Y4 each represent a hydrogen molecule, an alkyl group having 1 to 6 carbon atoms, an alkoxy group having 1 to 6 carbon atoms, an aralkyl group having 7 to 8 carbon atoms, a substituted or unsubstituted aryl group having 6 to 18 carbon atoms, a substituted or unsubstituted cyclohexyl group, a substituted or unsubstituted aryloxy group having 6 to 18 carbon atoms, or an alkoxy group having 1 to 6 carbon atoms.

The substituent herein is an alkyl group having 1 to 6 carbon atoms, an alkoxy group having 1 to 6 carbon atoms, an aralkyl group having 7 to 8 carbon atoms, an aryloxy group having 6 to 18 carbon atoms, an acyl group having 1 to 6 carbon atoms, an acyloxy group having 1 to 6 carbon atoms, a carboxyl group, a styryl group, an arylcarbonyl group having 6 to 20 carbon atoms, an aryloxycarbonyl group having 6 to 20 carbon atoms, an alkoxycarbonyl group having 1 to 6 carbon atoms, a vinyl group, an anilinocarbonyl group, a carbamoyl group, a phenyl group, a nitro group, a hydroxyl group, or a halogen.

The above-mentioned substituents may be used alone or in combination of two or more thereof. Y1 to Y4 may be the same or different from each other. Y1 and Y2, or Y3 and Y4 may each be bonded to the substituent to form a substituted or unsubstituted saturated 5-membered ring or a substituted or unsubstituted saturated 6-membered ring. Ar represents a substituted or unsubstituted arylene group having 6 to 20 carbon atoms, and may be substituted with a single substituent or plural substituents. The bonding moiety thereof may be any one of o-, p-, m-positions. However, in the case that Ar is an unsubstituted phenylene group, Y1 to Y4 are each selected from an alkoxy group having 1 to 6 carbon atoms, an aralkyl group having 7 to 8 carbon atoms, a substituted or unsubstituted naphthyl group, a biphenyl group, a cyclohexyl group, and an aryloxy group. Examples of such a distyrylarylene compound include the following:

[Chemical formula 2]

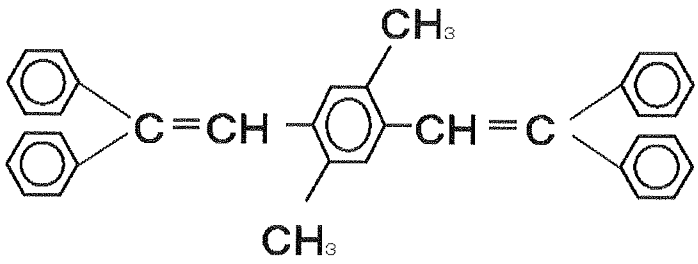

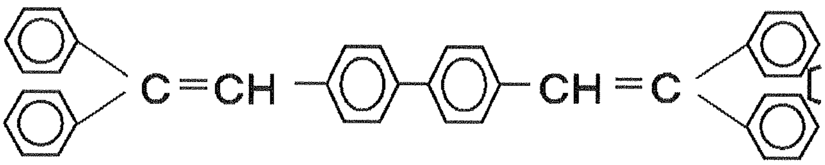

[DPVB1]

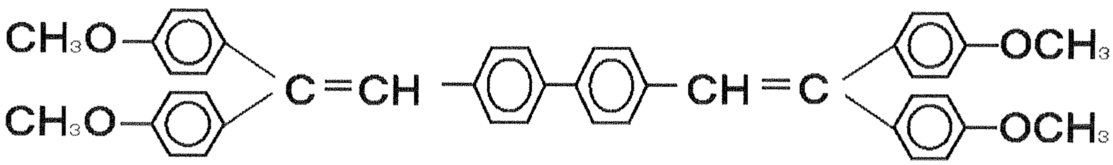

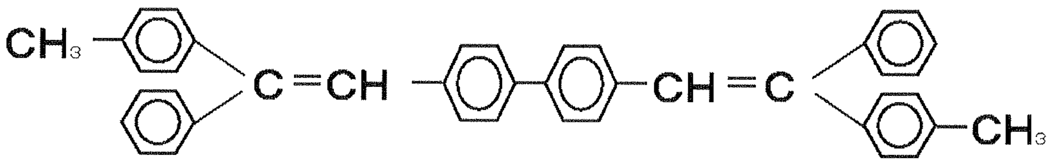

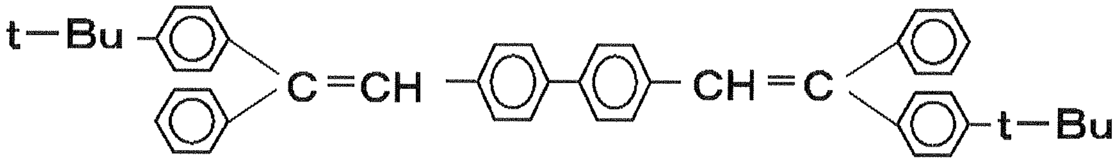

【t−Bu:t−butyl group】

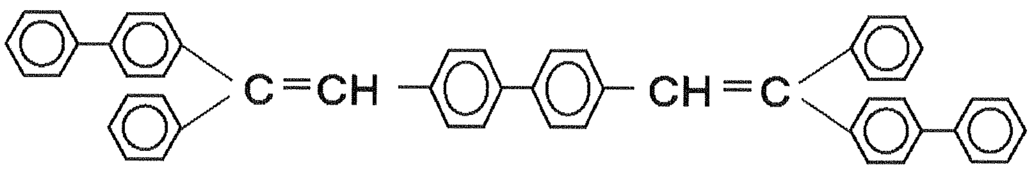

[Chemical formula 3]

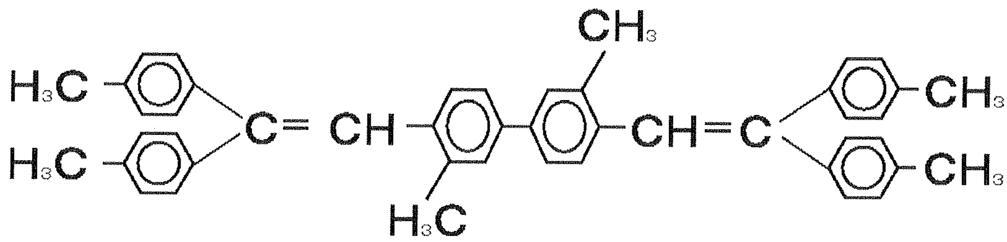

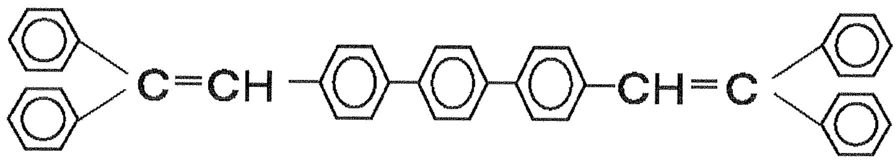

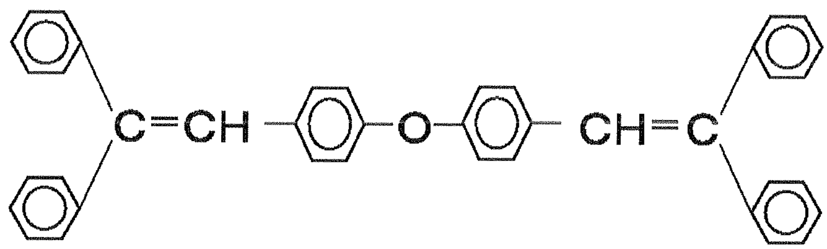

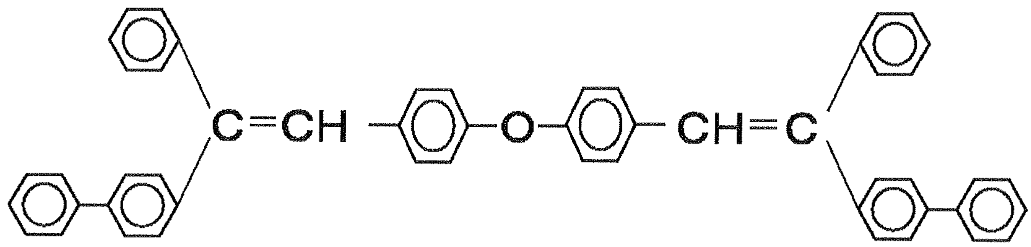

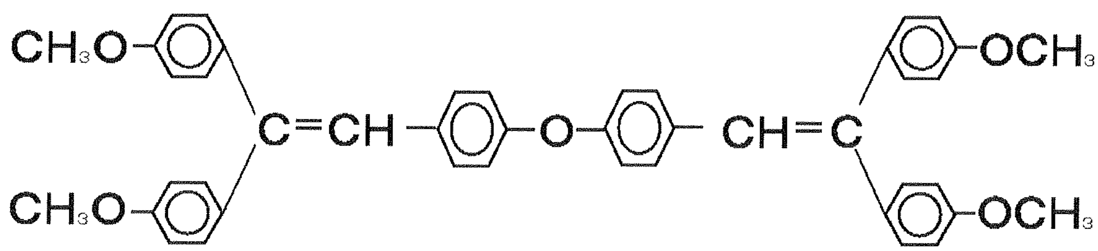

Other preferred examples of the light emitting material (host material) include metal complexes of 8-hydroxyquinoline or derivative thereof. A specific example thereof is a metal chelate oxanoid compound each containing a chelate of oxine (generally, 8-quinolinol or 8-hydroxyquinoline). Such a compound exhibits high-level performances and is easily formed into a thin film form. Examples of this oxanoid compound are compounds satisfying the following structural formulae:

[Chemical formula 4]

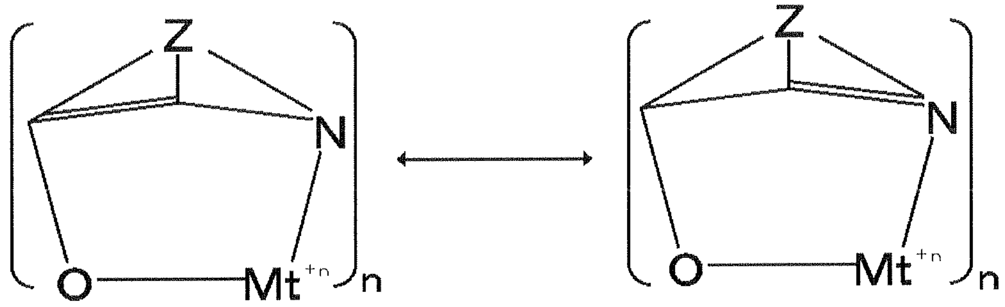

In the formulae, Mt represents a metal, n is an integer of 1 to 3, and Z represents atoms necessary for completing at least two or more condensed aromatic rings the positions of which are independent of each other.

The metal represented by Mt is a substance which can be made into a monovalent, bivalent or trivalent metal. Examples thereof include alkali metals such as lithium, sodium and potassium, alkaline earth metals such as magnesium and calcium, and earth metals such as boron and aluminum. In general, there can be used any one of monovalent, bivalent and trivalent metals which are known to be useful chelate compounds.

Z in the above-mentioned formulae represents atoms which form a heterocyclic ring in which one of at least two or more condensed aromatic rings is azole or azine. If necessary, a different ring may be added to the condensed aromatic rings. It is preferred to keep the number of the atoms represented by Z into the range of 18 or less to avoid a bulky molecule the function of which has not yet been improved. Specific examples of the chelated oxanoid compound include tris(8-quinolinol)aluminum, bis(8-quinolinol)magnesium, bis(benzo-8-quinolinol)zinc, bis(2-methyl-8-quinolinolato)aluminum oxide, tris(8-quinolinol)indium, tris(5-methyl-8-quinolinol)aluminum, 8-quinolinollithium, tris(5-chloro-8-quinolinol)gallium, bis(5-chloro-8-quinolinol)calcium, 5,7-dichloro-8-quinolinolaluminum, and tris(5,7-dibromo-8-hydroxyquinolinol)aluminum.

Furthermore, metal complexes of phenolate-substituted 8-hydroxyquinoline which are described in JP-A-5-198378 are preferred as blue light emitting materials. Specific examples of the metal complexes of phenolate-substituted 8-hydroxyquinoline include bis(2-methyl-8-quinolinolato)(phenolate)aluminum (III), bis(2-methyl-8-quinolinolato)(o-cresolate)aluminum (III), bis(2-methyl-8-quinolinolato)(m-cresolate)aluminum (III), bis(2-methyl-8-quinolinolato)(p-cresolate)aluminum (III), bis(2-methyl-8-quinolinolato)(o-phenylphenolate)aluminum (III), bis(2-methyl-8-quinolinolato)(m-phenylphenolate)aluminum (III), bis(2-methyl-8-quinolinolato) (p-phenylphenolate)aluminum (III), bis(2-metlayl-8-quinolinolato)(2,3 dimethylphenolate)aluminum (III), bis(2-methyl-8-quinolinolato)(2,6 dimethylphenolate)aluminum (III), bis(2-methyl-8-quinolinolato)(3,4 dimethylphenolate)aluminum (III), bis(2-methyl-8-quinolinolato)(3,5 dimethylphenolate)aluminum (III), bis(2-methyl-8-quinolinolato)(3,5-di-t-butylphenolate)alumi num (III), bis(2-methyl-8-quinolinolato)(2,6 diphenylphenolate)aluminum (III), and bis(2-methyl-8-quinolinolato)(2,4,6-triphenylphenolate)alum inum (III). These light emitting materials may be used alone or in combination of two or more thereof.

The light emitting layer will be more specifically described hereinafter. In general, in the case that white light is emitted, the light emitting layer is made into a bi-layered structure in many cases. These are called the first light emitting layer and the second light emitting layer.

For the first light emitting layer used in the present embodiment, various known light emitting materials can be used. The first light emitting layer is preferably a layer in which a green fluorescent colorant is added to the above-mentioned oxanoid compound in a very small amount of 0.2 to 3% by weight. The added green fluorescent colorant is a coumalin-based or quinacridon-based colorant. The addition of this colorant makes it possible that an element having the first light emitting layer realizes green light emission having a high efficiency of 5 to 20 (1m/w). In the case that yellow or orange color is required to be effectively taken out from the first light emitting layer, there is used a layer in which rubrene or a derivative thereof, a dicyanopyran derivative, or a perylene derivative is added to the oxanoid compound in an amount of 0.2 to 3% by weight. The element can emit or output light at a high efficiency of 3 to 10 (lm/w). Simultaneous addition of a green fluorescent colorant and a red fluorescent colorant also makes orange emission possible. Preferably, the following are simultaneously used: for example, coumalin and a dicyanopyran colorant, quinacridon and a perylene colorant, or coumalin and a perylene colorant. A different particularly preferred example of the first light emitting layer is a polyarylene vinylene derivative. This makes it possible to output green or orange color effectively.

For the second light emitting layer used in the present embodiment, various known blue light emitting materials can be used. For example, distyrylarylene derivatives, tristyrylarylene derivatives, and allyloxyquinolato metal complexes are blue light emitting materials capable of emitting blue light having a high purity effectively. Examples of the polymer

include polyparaphenylene derivatives.

The method for forming the light emitting layer in the organic EL element used in the embodiment is, for example, formation of a thin film by a known method such as vapor deposition, spin coating, casting or LB technique. It is particularly preferred that it is a molecule deposited film. The molecule deposited film is a film formed by deposition of the compound in a gas phase state, or a film formed by solidifying the compound in a melt state or liquid phase state. Usually, this molecule deposited film can be distinguished from any thin film formed by LB technique (molecule accumulated film) from the viewpoint of difference in aggregated structure or high-order structure, or functional difference resulting therefrom. This light emitting layer can be formed by dissolving them together with a binder, such as resin, into a solvent to prepare a solution and then making this into a thin film by spin coating or the like. The film thickness of the light emitting layer formed in this way is not particularly limited, and can be appropriately selected in accordance with the situation. The thickness is preferably from 1 nm to 10 μm, in particular preferably from 5 nm to 5 μm.

<u>(8) Hole injecting layer</u>

A hole injecting layer is not an essential structure for the organic EL display device 100. However, the layer is ordinarily used to improve the luminous performance. Therefore, in the present embodiment also, an example in which the hole injecting layer is used will be described hereinafter.

This hole injecting layer is a layer which helps the injection of holes into the light emitting layer. Usually, the layer is preferably a layer having a large hole mobility and a small ionization energy of 5.5 eV or less. For such a hole injecting layer, a material for transporting holes to the light emitting layer at a lower electric field is preferred. The hole mobility is more preferably at least $10^{-6}$ $cm^2$/V·second (that is, $10^{-6}$ $cm^2$/ V·second or more) when, for example, an electric field of $10^4$ to $10^6$ V/cm is applied. Such a hole injecting material is not particularly limited as long as the material has the above-mentioned preferred natures. Thus, it is allowable to use a material selected at will from materials used commonly as charge transporting materials for holes or known materials used in a hole injecting layer of EL elements among photoconductive materials in the prior art.

Specific examples thereof include triazole derivatives (see USP No. 3,112,197 specification), oxadiazole derivatives (see USP No. 3,189,447 specification), imidazole derivatives (JP-B-37-16096), polyarylalkane derivatives (see USP Nos. 3,615,402, 3,820,989, and 3,542,544 specifications, and JP-B-45-555, 51-10983, 55-17105, 56-4148, 55-108667, 55-156953 and 56-36656), pyrazoline derivatives and pyrazolone derivatives (USP Nos. 3,180,729 and 4,278,746 specifications, JP-A-55-88064, 55-88065, 49-105537, 55-51086, 56-80051, 56-88141, 57-45545, 54-112637 and 55-74546).

Additional specific examples thereof include phenylenediamine derivatives (see USP No. 3,615,404 specification, JP-B-51-10105, 46-3712 and 47-25336, and JP-A-54-53435, 54-110536and54-119925), arylamine derivatives (USP Nos. 3,567,450,3,180,703,3,240,597, 3,658,520,4,232,103, 4,175,961 and 4,012,376 specifications, JP-B-49-35702 and 39-27577, JP-A-55-144250, 56-119132 and 56-22437, and DE Patent No. 1,110,518 specification), amino-substituted calcone derivatives (see USP No. 3,526,501 specification), oxazole derivatives (those disclosed in USP No. 3,257,203 specification), fluorene derivatives (see JP-A-54-110837), hydrazone derivatives (see USP No. 3,717,462 specification, and JP-A-54-59143, 55-52063, 55-52064, 55-46760, 55-85495, 57-11350, 57-148749 and 2-311591), styrylanthracene derivatives (see JP-A-56-46234), stylbene derivatives (see JP-A-61-210363, 61-228451, 61-14642, 61-72255, 62-47646, 62-36674, 62-10652, 62-30255, 60-93445, 60-94462, 60-174749 and 60-175052), silazane derivatives (see USP No. 4,950,950 specification), polysilanes (JP-A-2-204996), aniline based copolymers (JP-A-2-282263), and electroconductive macromolecular oligomers (in particular, thiophene oligomers) disclosed in JP-A-1-211399.

As the material of the hole injecting layer, although the above can be used, the following are preferably used: porphyrin compounds (compounds disclosed in JP-A-63-2956965), aromatic tertiary amine compounds and stilamine compounds (see USP No. 4,127,412, and JP-A-53-27033, 54-58445, 54-149634, 54-64299, 55-79450, 55-144250, 56-119132, 61-295558, 61-98353 and 63-295695), in particular, aromatic tertiary amine compounds.

Typical examples of the porphyrin compounds include porphine, 1,10,15,20-tetraphenyl-21H,23H-porphinecopper (II), 1,10,15,20-tetraphenyl-21H,23H-porphine zinc (II), 5,10,15,20-tetrakis (pentafluorophenyl)-21H,23H-porphine, siliconephthalocyanineoxide, aluminumphthalocyaninechloride, phthalocyanine (metal-free), dilithium phthalocyanine, copper tetramethylphthalocyanine, copper phthalocyanine, chromium phthalocyanine, zinc phthalocyanine, lead phthalocyanine, titanium phthalocyanineoxide, Mg phthalocyanine, and copper octamethylphthalocyanine.

Typical examples of the aromatic tertiary amine compounds and the styrylamine compounds include N,N,N',N'-tetraphenyl-4,4'-diaminophenyl, N,N'-diphenyl-N,N'-bis-(3-methylphenyl)-[1,1'-biphenyl]-4,4 '-diamine (hereinafter abbreviated to TPD), 2,2-bis(4-di-p-tolylaminophenyl)propane, 1,1-bis(4-di-p-tolylaminophenyl)cyclohexane, N,N,N',N'-tetra-p-tolyl-4,4'-diaminophenyl, 1,1-bis(4-di-p-tolylaminoethyl)-4-phenylcyclohexane, bis(4-dimethylamino-2-methylphenyl)phenylmethane, bis(4-di-p-tolylaminophenyl)phenylmethane, N,N'-diphenyl-N,N'-di(4-methoxyphenyl)-4,4'-diaminobiphenyl, N,N,N',N'-tetraphenyl-4,4'-diaminophenyl ether, 4,4'-bis(diphenylamino)quadriphenyl, N,N,N-tri(p-tolyl)amine, 4-(di-p-tolylamino)-4'-[4(di-p-tolylamino)styryl]stylbene, 4-N,N-diphenylamino-(2-diphenylvinyl)benzene, 3-methoxy-4'-N,N-diphenylaminostylbenzene, N-phenylcarbazole, compounds having, in their molecule, two condensed aromatic rings, and described in USP No. 5,061,569 specification, such as 4,4'-bis[N-(1-naphthyl)-N-phenylamino]biphenyl (hereinafter abbreviated to NPD), 4,4',4"-tris[N-(3-methylphenyl)-N-phenylamino]triphenylamin e (hereinafter abbreviated to MTDATA), which is described in JP-A-4-308688, in which three triphenylamine units are connected to each other into a star-burst form.

Besides the above-mentioned aromatic dimethylidene compounds described as the material of the light emitting layer, inorganic compounds, such as p-type Si, p-type SiC, can also be used as the material of the hole injecting layer. The hole injecting layer can be formed by making one or more of the above-mentioned compounds into a thin film by a known method such as vacuum evaporation, span coating, casting, or LB technique. The film thickness of the hole injecting layer is not particularly limited, and is usually from 5 nm to 5 μm. This hole injecting layer may be a monolayer made of one or more of the above-mentioned materials, or may be a product obtained by laminating, on the above-mentioned hole injecting monolayer, a hole injecting layer made of a compound different from that in the monolayer. The organic semiconductor layer is a layer for assisting the injection of holes or electrons into the light emitting layer, and preferably has an electroconductivity of $10^{-10}$ S/cm or more. As the material of such an organic semiconductor layer, the following can be used: an electroconductive oligomer such as thiophene-containing oligomer or arylamine-containing oligomer; an electroconductive dendrimer such as an arylamine-containing dendrimer; or the like.

(9) Electron injecting layer/adhesion improving layer

The electron injecting layer is a layer, in which many electrons shift, for assisting the injection of electrons into the light emitting layer. The adhesion improving layer is a layer made of a material having a good adhesive property, in particular, to the cathode out of such electron injecting layers. Preferred examples of the material used in the electron injecting layer include metal complexes of 8-hydroxyquinoline or any derivative thereof, and oxadiazole derivatives. As the material used in the adhesion improving layer, metal complexes of 8-hydroxyquinoline or any derivative thereof are particularly preferred. Specific examples of the metal complexes of 8-hydroxyquinoline or any derivative thereof include metal chelate oxanoid compounds containing a chelate of oxine (generally, 8-quinolinol or 8-hydroxyquinoline). In the meantime, examples of the oxadiazole derivatives include compounds represented by the following general formulae (II), (III) and (IV):

[Chemical formula 5]

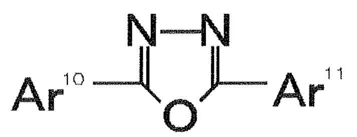
···(II)

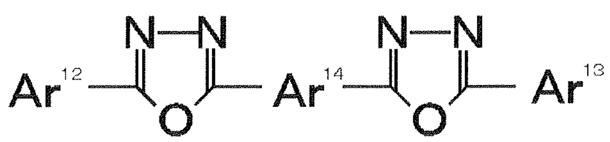
···(III)

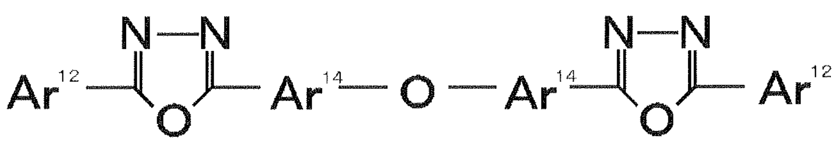
···(IV)

In each of the formulae, Ar10 to Ar13 each represent a substituted or unsubstituted aryl group, and Ar10 and Ar 11 may be the same or different, as well as Ar12 and Ar13. Ar14 represents a substituted or unsubstituted arylene group.

The oxadiazole derivatives may be electron transmissible compounds represented by these formulae. Examples of the aryl group herein include phenyl, biphenyl, anthranyl, perylenyl, and pyrenyl groups, and examples of the arylene group herein include phenylene, naphthylene, biphenylene, anthracenylene, perylenylene, and pyrenylene groups. Examples of the substituent include alkyl groups having 1 to 10 carbon atoms, alkoxy groups having 1 to 10 carbon atoms, and a cyano group. The electron transmissible compounds are preferably compounds capable of being made into a thin film. Specific examples of the electron transmissible compounds include compounds represented by the following formulae:

[Chemical formula 6]

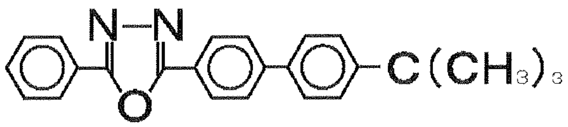 ···(PBD)

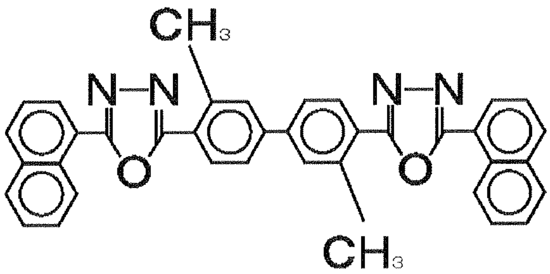

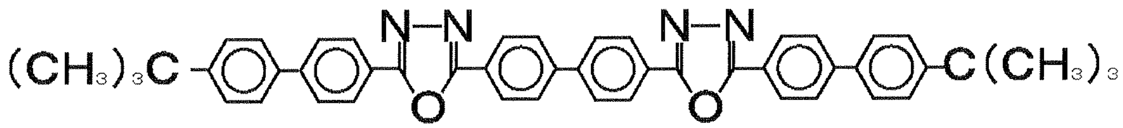

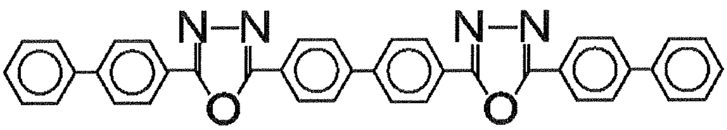

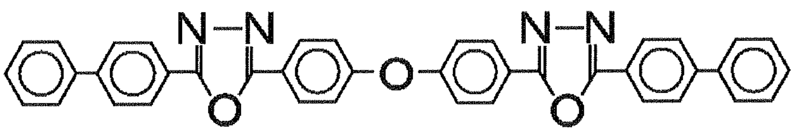

(10) Cathode 20

The cathode 20 may be an electrode in which a metal, alloy or electroconductive compound having a small work function (4 eV or less), or a mixture thereof is rendered an electrode material. Specific examples of such an electrode material include sodium, sodium-potassium alloy, magnesium, lithium, magnesium/silver alloy, aluminum/aluminum oxide ($Al_2O_3$), aluminum/lithium alloy, indium, and rare earth metals. This cathode 20 can be formed by making one or

more of these electrode materials into a thin film by vapor deposition, sputtering or some other method. The sheet resistance of the cathode 20 is preferably several hundreds of $\Omega/m^2$ or less, and the film thickness is usually selected in the range of 10 nm to 1 μm, and is in particular preferably from 50 to 200 nm.

In the organic EL element used in the present embodiment, it is preferred that either of the anode 16 or cathode 20 is transparent or semitransparent. When either of the anode 16 or cathode 20 is transparent or semitransparent, the anode 16 or cathode 20 transmits emitted light so that a good efficiency of taking out the light is exhibited.

(11) Method for laminating the layers constituting the organic EL element 122

a. Anode 16 (substrate electrode)

An electrode laminated on the side of the substrate 12 is called a substrate electrode. Accordingly, the above-mentioned anode 16 is a substrate electrode. The method for laminating the substrate electrode is not particularly limited, and preferred examples thereof include dry film forming methods such as vapor deposition, sputtering, ion plating, electron beam vapor deposition, CVD (chemical vapor deposition), MOCVD (metal organic CVD), and plasma CVD. The anode 16 is also laminated by such a laminating method.

b. Organic substance layer 18

The layer is laminated by the same method as described in the above-mentioned "(7) Light emitting layer".

c. Counter electrode

An electrode countering the substrate electrode is called a counter electrode. Accordingly, the above-mentioned cathode 20 is a counter electrode. The counter electrode is also laminated by the same method as used for the substrate electrode.

Examples

The following will describe examples about the CCM electrode substrate of the present embodiment and an organic EL display device (CCM panel) in which an organic EL element is constructed on the electrode substrate while specific values are given.

[Example 1]

In Example 1, it is demonstrated that in the case of forming the surface protecting layer 102 on the anode 16 on the CCM substrate 124, which may be called the CCM electrode substrate, whereby the CCM substrate 124 is used to produce the organic EL display device 122, which may be called the CCM panel, performances of the organic EL display device 122 become high.

[1] Production 1 of the CCM substrate 124 (color converting substrate) (up to the formation of a color converting film)

A V259 BK (manufactured by Nippon Steel Chemical Co., Ltd.) was applied as a material of a black matrix (BM) onto a 102 mm × 133 mm × 1.1 mm supporting substrate (OA2 glass, manufactured by Nippon Electric Glass Co., Ltd.) by spin coating, and then the resultant was exposed to ultraviolet rays so as to give a lattice form pattern. The resultant was developed with a 2% solution of sodium carbonate in water, and then baked at 200°C to form a black matrix pattern (film thickness: 1.5 μm).

Next, a V259B (manufactured by Nippon Steel Chemical Co., Ltd.) was applied thereto as a material of a blue color filter by spin coating. The resultant was exposed to ultraviolet rays through a photomask for giving a rectangular pattern of 320 stripes (90 μm lines and 240 μm gaps) while the mask was positioned to the BM. The resultant was developed with a 2% solution of sodium carbonate in water, and then baked at 200°C to form a blue color filter pattern (film thickness: 1.5 μm).

Next, a V259G (manufactured by Nippon Steel Chemical Co., Ltd.) was applied thereto as a material of a green color filter by spin coating. The resultant was exposed to ultraviolet rays through a photomask for giving a rectangular pattern of 320 stripes (90 μm lines and 240 μm gaps) while the mask was positioned to the BM. The resultant was developed with a 2% solution of sodium carbonate in water, and then baked at 200°C to form a green color filter pattern (film thickness: 1.5 μm) adjacent to the blue color filter.

Next, a V259R (manufactured by Nippon Steel Chemical Co., Ltd.) was applied thereto as a material of a red

color filter by spin coating. The resultant was exposed to ultraviolet rays through a photomask for giving a rectangular pattern of 320 stripes (90 μm lines and 240 μm gaps) while the mask was positioned to the BM. In this way, a red color filter pattern (film thickness: 1.μm) was formed between the blue color filter and the green color filter.

Next, as a material of a green CCM layer 14G, prepared was an ink in which coumalin 6, the amount of which was an amount that would be 0.04 mol/kg (to solids), was dissolved in an acrylic negative photoresist (V259PA, manufactured by Nippon Steel Chemical Co., Ltd., solid content: 50%).

This ink was applied onto the above-mentioned substrate by spin coating, and ultraviolet rays were radiated onto the green color filter. The resultant was developed with a 2% solution of sodium carbonate in water, and then baked at 200°C to form a green converting film pattern (film thickness: 10 μm) on the green color filter.

Next, as a material of a red CCM layer 14R, prepared was an ink in which 0.53 g of coumalin 6, 1.5 g of basic violet 11, and 1.5 g of rhodamine 6G were dissolved in 100 g of an acrylic negative photoresist (V259PA, manufactured by Nippon Steel Chemical Co., Ltd., solid concentration: 50%).

This ink was applied onto the above-mentioned substrate by spin coating, and ultraviolet rays were radiated onto the red color filter. The resultant was developed with a 2% solution of sodium carbonate in water, and then baked at 180°C to form a red converting film pattern (film thickness: 10 μm) on the red color filter. In this way, a color converting substrate was yielded.

<u>[2] Production 2 of the CCM substrate 124 (color converting substrate) (up to the formation of a flattening film, anode 16, and partition walls)</u>

Next, an acrylic thermosetting resin (V259PH, manufactured by Nippon Steel Chemical Co., Ltd.) was applied, as a flattening film, onto the above-mentioned substrate by spin coating, and the resultant was baked at 180°C to form the flattering film (film thickness: 5 μm).

Next, SiOxNy (O/O + N = 50%: atomic ratio) was formed into a transparent inorganic film as an oxygen blocking layer by low temperature CVD so as to have a thickness of 200 nm. The water vapor permeability was less than 0.1 $g/m^2 \cdot day$.

Next, IZO (indium zinc oxide) was formed into a film of 200 nm thickness by sputtering.

Next, on this substrate, a positive resist (HPR204, manufactured by FUJIFILM Arch Co., Ltd.) was positioned to be overlapped with the CCM layer or color filter pattern in the state that a photomask having a stripe pattern of 90 μm lines and 20 μm gaps was interposed therebetween. The resultant was exposed to ultraviolet rays, developed with a developing solution of TMAH (tetramethylammonium hydroxide), and then baked at 130°C to yield a resist pattern.

Next, IZO of the uncovered portions was etched with an IZO etchant made of a 5% solution of oxalic acid in water. Next, the resist was treated with a releasing solution (N303, manufactured by Nagase & Co. , Ltd.) made mainly of ethanolamine to yield an IZO pattern (lower electrode: anode 16, the number of lines: 960).

Next, a negative resist (V259PA, manufactured by Nippon Steel Chemical Co., Ltd.) was applied as a first interlayer dielectric by spin coating, exposed to ultraviolet rays, and developed with a developing solution of TMAH (tetramethylammonium hydroxide). Next, the resultant was baked at 180°C to cover edges of ITO, thereby making each opening in IZO into 70 μm × 290 μm.

Next, a negative resist (ZPN1100, manufactured by Nippon Zeon Co., Ltd.) was applied as a second interlayer dielectric (partition walls) by spin coating, and exposed to ultraviolet rays through a photomask for giving a stripe pattern of 20 μm lines and 310 μm gaps. After the exposure, the resultant was baked. Next, the negative resist was developed with a developing solution of TMAH (tetramethylammonium hydroxide) to form the second interlayer dielectric (partition walls), which was an organic film crossing the IZO stripes at right angles.

<u>[3] Production 3 of the CCM substrate 124 (color converting substrate) (the formation of the surface protecting layer 102 on the anode 16)</u>

A film of $SiO_2$ was formed into a thickness of 20 Å on the substrate in which the interlayer dielectrics were formed as described above by inductively coupled RF plasma supported magnetron sputtering (hereinafter called helical sputtering). Details of steps therefor are as follows:

The substrate was washed, and then the washed substrate was set into a sputtering chamber. The chamber was subjected to degassing into a vacuum. In the machine used in the experiment, the distance from the target of $SiO_2$ to the substrate was 30 cm.

It was ascertained that the vacuum degree became $2.0 \times 10^4$ Pa or less, and then 80 sccm of Ar as an electric discharge gas was introduced through a mass flow controller. The vacuum degree at this time was 0.38 Pa.

In the state that a main shutter just above the target was shut, a high frequency wave having a power of 50 W was applied to inductively coupling coils for a frequency of 13.56 MHz, and a high frequency wave having a power of 500 W and the same frequency of 13.56 MHz was applied to the $SiO_2$ target (cathode) to cause plasma discharge.

Reflection of each of the coils was 5 W or less. In this state, in which the main shutter was shut, the discharge was continued for 5 minutes to clean the surface of the $SiO_2$ target.

Thereafter, the main shutter was opened, and then a film was formed by plasma discharge for 6 minutes 20 seconds, which was presumed from the value of the film-forming rate measured in advance. As a result, $SiO_2$ having a film thickness of 20 Å was formed on IZO.

[4] Formation of an organic EL element on the CCM substrate 124 (color converting substrate), and panel-sealing

The thus obtained substrate was subjected to ultrasonic washing in pure water and isopropyl alcohol, and was dried with a dry nitrogen blow.

The substrate was shifted to inside of an organic vapor deposition machine (manufactured by ULVAC Japan, Ltd.), and the substrate was fixed on a substrate holder.

The organic vapor deposition machine was provided with heating ports made of molybdenum. Various materials were beforehand charged into the individual heating ports made of molybdenum.

Specifically, as hole injecting materials, charged were 4,4',4"-tris[N-(3-methylphenyl)-N-phenylamino]triphenylamin e (MTDATA) and 4,4'-bis[N-(1-naphthyl)-N-phenylamino]biphenyl (NPD). As a host of a light emitting material, charged was 4,4'-bis(2,2-diphenylvinyl)biphenyl (DPVBi). As a dopant, charged was 1,4-bis[4-(N,N-diphenylaminostyrylbenezene)] (DPAVB). As electron injecting materials, charged were tris(8-quinolinol)aluminum (Alq) and Li. Furthermore, Al was charged for a cathode 20.

Thereafter, the pressure in the vacuum chamber was reduced into $5 \times 10^{-7}$ torr, and then layers from a hole injecting layer to the cathode 20 were laminated through the following steps. In the middle of the laminating steps, the individual layers were successively laminated by one vacuum drawing operation without breaking the vacuum.

First, for the hole injecting layer, MTDATA was formed into a film of 60 nm film thickness at a deposition rate of 0.1 to 0.3 nm/second, and further NPD was formed into a film of 20 nm film thickness at a deposition rate of 0.1 to 0.3 nm/second. For a light emitting layer, DPVBi and DPAVB were co-deposited into a film of 50 nm film thickness at a deposition rate of 0.1 to 0. 3 nm/second and a deposition rate of 0. 03 to 0.05 nm/second, respectively. For an electron injecting layer, Alq was formed into a film of 20 nm film thickness at a deposition rate of 0.1 to 0.3 nm/second. Furthermore, Alq and Li were co-deposited into a film of 20 nm film thickness at a deposition rate of 0.1 to 0.3 nm/second and a deposition rate of 0.005 nm/second, respectively. Lastly, for the cathode 20, Al was formed into a film of 150 nm film thickness at a deposition rate of 0.1 to 0.3 nm/second, so as to make the cathode 20. In this way, an organic EL element was produced.

Next, this substrate was moved into a glove box in which dry nitrogen (dew point: -50°C) was circulated, and then its display section was covered with a 102 mm $\times$ 133 mm $\times$ 1.1 mm blue glass. The periphery of the display device section was stuck by photo-curing a cationic curable adhesive (TB3102, manufactured by Three Bond Co. , Ltd.), so as to produce a passive organic EL display device.

[5] Driving estimation of the color converting panel sealing

A voltage of 15 V was applied to the lower electrode (the anode 16: IZO) and the upper electrode (the cathode 20: Al) (the lower electrode: (+), and the upper electrode: (-)) at a duty ratio of 1/120. As a result, crossing paints of the electrodes (pixels) emitted light.

About the luminance of the emitted light, the following was obtained with a color-difference meter (CS100, manufactured by Minolta Co., Ltd.): in the blue color filter section (blue pixels), blue luminescence having a luminance of 16 cd/$m^2$ and CIE chromaticity coordinates of X = 0.15 and Y = 0.16; in the green CCM layer/green color filter section (green pixels), green luminescence having a luminance of 45 cd/$m^2$ and CIE chromaticity coordinates of X = 0.27 and Y = 0. 67; and in the red CCM layer/red color filter section (red pixels), red luminescence having a luminance of 15 cd/$m^2$ and CIE chromaticity coordinates of X = 0. 64 and Y = 0.35. Thus, the three primary colors of light were obtained.

The luminance of the light emitted from the organic EL element at this time was 200 cd/$m^2$ (corresponding to the light emitted from all the pixels). The light was blue light in which the CIE chromaticity coordinates were X = 0.17 and Y = 0.28.

Next, under the driving conditions, the element was driven at 22°C for 1000 hours. As a result, the luminance of the blue pixels was 10 cd/$m^2$ (the ratio thereof to the initial value converted to 1 was 0.67), the luminance of the green pixels was 27 cd/$m^2$ (the ratio thereof to the initial value converted to 1 was 0.60), and the luminance of the red pixels was 9 cd/$m^2$ (the ratio thereof to the initial value converted to 1 was 0.60). The luminance of the organic EL element was 126 cd/$m^2$ (the ratio thereof to the initial value = 1 was 0.63).

An organic EL element produced through the above-mentioned film-forming steps but provided with no CCM was sealed with an ordinary inert gas such as dry nitrogen. In this case, about a deterioration in the luminance of the organic EL element, the ratio under the same driving conditions as described above was 0.65 when the initial value was

converted to one.

[Comparative Example 1]

In the [3] Production of the CCM substrate 124 (the formation of the surface protecting layer 102 on the anode 16) in Example 1, the film-forming step of $SiO_2$ as the surface protecting layer 102 was not carried out, and immediately the processing of the [4] Formation of an organic EL element on the CCM substrate 124, and panel-sealing was performed in the very same manner to produce an organic EL display device (organic EL panel). In the same manner as in Example 1, the processing of the [5] Driving estimation of the color converting panel sealing was performed. The following results were obtained.

About the luminance of the emitted light, the following was obtained with a color-difference meter (CS100, manufactured by Minolta Co., Ltd.): in the blue color filter section (blue pixels), blue luminescence having a luminance of 11 cd/$m^2$ and CIE chromaticity coordinates of X = 0.15 and Y = 0.16; in the green CCM layer/green color filter section (green pixels), green luminescence having a luminance of 33 cd/$m^2$ and CIE chromaticity coordinates of X = 0.27 and Y = 0. 67; and in the red CCM layer/red color filter section (red pixels), red luminescence having a luminance of 12 cd/$m^2$ and CIE chromaticity coordinates of X = 0. 64 and Y = 0.36. Thus, the three primary colors of light were obtained.

The luminance of the light emitted from the organic EL element at this time was 150 cd/$m^2$ (corresponding to the light emitted from all the pixels). The light was blue light in which the CIE chromaticity coordinates thereof were X = 0.17 and Y = 0.27.

Next, under the driving conditions, the element was driven at 22°C for 1000 hours. As a result, the luminance of the blue pixels was 6 cd/$m^2$ (the ratio thereof to the initial value converted to 1 was 0.55), the luminance of the green pixels was 16 cd/$m^2$ (the ratio thereof to the initial value converted to 1 was 0.48), and the luminance of the red pixels was 6 cd/$m^2$ (the ratio thereof to the initial value converted to 1 was 0.50) . The luminance of the organic EL element was 84 cd/$m^2$ (the ratio thereof to the initial value = 1 was 0.56).

An organic EL element on the substrate not subjected to the film-forming steps of the surface protecting layer and provided with no CCM was sealed with an ordinary inert gas such as dry nitrogen. In this case, about a deterioration in the luminance of the organic EL element, the ratio under the driving conditions was 0.58 when the initial value was converted to one.

It can be understood from the above-mentioned results that when the surface protecting layer 102 is formed on IZO, which is the anode 16 of the CCM substrate 124, the luminances of the individual colors on the basis of the same voltage become larger than when the surface protecting layer 102 is not formed. In short, according to the present example, an improvement in the luminous efficiency can be demonstrated.

The following can also be understood: in the element in which the surface protecting layer 102 is formed, the advancing rate of the deterioration in the luminescence is made lower than in the element in which the layer 102 is not formed in the case of driving the elements continuously.

As described above, it is demonstrated that in the case of forming the surface protecting layer 102 on the anode 16, the luminous performance is improved and further the stability (that is, the lifespan) of the panel which is continuously driven is improved.

Embodiment 2: example having a structure which contains TFTs

In the example illustrated in Fig. 1, the anode 16 is illustrated on the CCM layer 14. In Fig. 1, the system for driving this anode 16 is not particularly described. It is preferred to drive the anode 16 by means of, for example, TFTs (thin film transistors). Such a structure is illustrated in Fig. 3. In Fig. 3, a schematic sectional view of a moiety for one color in the one pixel illustrated in Fig. 1 is shown. In other words, a moiety for any one color of the red, blue and green colors in Fig. 1 is shown.

As illustrated in this figure, in the present embodiment, a CCM layer 14 is formed in a substrate 12. On the CCM layer 14, an overcoat layer 210 and a passivation film 212 are formed. On the passivation film 212, a gate 226 of a thin film transistor 220 is formed, and further an insulating film 230 is laminated thereon so as to cover the gate.

An anode 16, and a drain 224 and a source 222 of the thin film transistor 220 for driving this anode 16 are formed on the insulating film 230. The drain 224 is electrically connected to the anode 16.

A characteristic of the present embodiment 2 is that the anode 16 is driven by means of the thin film transistor (TFT). An electric power is supplied to the anode 16 by an electric potential applied to the gate 226 of this thin film transistor 220. The thin film transistor 220 corresponds to one example of the "driving element" in the claims.

One of the characteristics of the present invention is that the surface protecting layer 102 is formed on the anode 16. The present embodiment 2 demonstrates that it is allowable that the thin film transistor 220 is formed as a layer of the same level at which this anode is formed.

In other words, in the embodiment 2, an essential point different from the embodiment in Fig. 2 is only that the

anode 16 is driven by means of the thin film transistor 220. Specifically, the surface protecting layer 102 is formed on the anode and the thin film transistor 220 in the same manner as illustrated in Fig. 1. This surface protecting layer is identical with the surface protecting layer 102 which has been described hereinbefore.

In the same manner as illustrated in Fig. 1, an organic substance layer 18 and a cathode 20 are formed on the surface protecting layer 102. Thus, the whole thereof is constructed as an organic EL display device 200.

In the embodiment 2, an example in which the thin film transistor 220 is used as the system for driving the anode 16 has been described. Of course, however, other various driving elements/driving systems can be appropriately adopted.

## Claims

**1.** An electrode substrate comprising:

a substrate;
an electrode comprising an In atom containing compound; and
a fluorescence converting layer which is a layer positioned between the electrode and the substrate in order to convert the wavelength of light radiated into this layer,

wherein a surface protecting layer comprising an inorganic compound is formed on a surface of the electrode which is a surface opposite to an electrode surface facing the fluorescence converting layer.

**2.** The electrode substrate according to claim 1, wherein the constituting material of the substrate and/or the electrode is a transparent material.

**3.** The electrode substrate according to claim 1 or 2, wherein the electrode is an electrode subjected to reverse sputtering treatment.

**4.** The electrode substrate according to claim 3, wherein the reverse sputtering treatment is a reverse sputtering treatment based on inductively coupled RF plasma supported magnetron sputtering.

**5.** The electrode substrate according to any one of claims 1 to 4, wherein the inorganic compound which constitutes the surface protecting layer is any one of an oxide, a nitride, a complex oxide, a sulfide, and a fluoride of at least one selected from Ba, Ca, Sr, Yb, Al, Ga, In, Li, Na, K, Cd, Mg, Si, Ta, Ge, Sb, Zn, Cs, Eu, Y, Ce, W, Zr, La, Sc, Rb, Lu, Ti, Cr, Ho, Cu, Er, Sm, W, Co, Se, Hf, Tm, Fe and Nb.

**6.** The electrode substrate according to claim 5, wherein the surface protecting layer is formed by sputtering.

**7.** The electrode substrate according to claim 6, wherein the surface protecting layer is formed by sputtering using inductively coupled RF plasma supported magnetron sputtering.

**8.** The electrode substrate according to any one of claims 1 to 7, wherein the film thickness of the surface protecting layer is a value within the range of 5 to 100 Å.

**9.** The electrode substrate according to any one of claims 1 to 8, wherein the electrode comprises indium tin oxide (ITO) or indium zinc oxide (IZO).

**10.** The electrode substrate according to claim 9, wherein the electrode is an amorphous oxide.

**11.** The electrode substrate according to any one of claims 1 to 10, comprising a driving element for driving the electrode.

**12.** A method for producing an electrode substrate, the electrode substrate comprising:

a substrate;
an electrode comprising an In atom containing compound; and
a fluorescence converting layer which is a layer positioned between the electrode and the substrate in order to convert the wavelength of light radiated into this layer,
the method comprising the steps of:

forming the fluorescence converting layer on the substrate;
forming the electrode on the formed fluorescence converting layer; and
subjecting the surface of the formed electrode to reverse sputtering treatment,

wherein, in the step of subjecting the electrode surface to the reverse sputtering treatment, a surface protecting layer comprising an inorganic compound is formed after or when the reverse sputtering treatment is carried out.

**13.** The electrode substrate producing method according to claim 12, wherein the reverse sputtering treatment is carried out using inductively coupled RF plasma supported magnetron sputtering.

**14.** The electrode substrate producing method according to claim 13, wherein in the reverse sputtering treatment,
a high frequency wave having an electric power of 50 to 200 W and a frequency of 13.56 to 100 MHz is applied to a helical coil for the inductively coupled RF plasma supported magnetron sputtering,
a high frequency wave having an electric power of 200 to 500 W and a frequency of 13.56 to 100 MHz is applied to a cathode for the inductively coupled RF plasma supported magnetron sputtering, thereby causing plasma discharge, and
the intensity of a magnetron magnetic field for the inductively coupled RF plasma supported magnetron sputtering is set to a value within the range of 200 to 300 gausses.

**15.** The electrode substrate according to claim 1,
wherein, when the full-width half-maximum of a peak of the $3d_{5/2}$ orbital spectrum of the In atoms measured in the surface facing the surface protecting layer by X-ray photoelectron spectroscopy is represented by $[In3d_{5/2}]_n$,
the value of $([In3d_{5/2}]_h/[In_3d_{5/2}]_n)$, which is the ratio between the respective full-width half-maximums, is within the range of 0.9 to 1.2.

**16.** The electrode substrate according to claim 1,
wherein, when the value of a peak of the $3d_{5/2}$ orbital spectrum of the In atoms measured in the electrode by X-ray photoelectron spectroscopy is represented by In peak,
the value of a peak of the $3d_{5/2}$ orbital spectrum of Sn atoms measured in the electrode by X-ray photoelectron spectroscopy is represented by Sn peak,
the ratio between the respective peaks measured in the surface of the electrode is represented by $(\text{In peak/Sn peak})_h$, and
the ratio between the respective peaks measured inside the electrode is represented by $(\text{In peak/Sn peak})_n$,
the following is satisfied: $((\text{Sn peak/In peak})_h/(\text{Sn peak/In peak})_n) < 1.5$.

Fig. 1

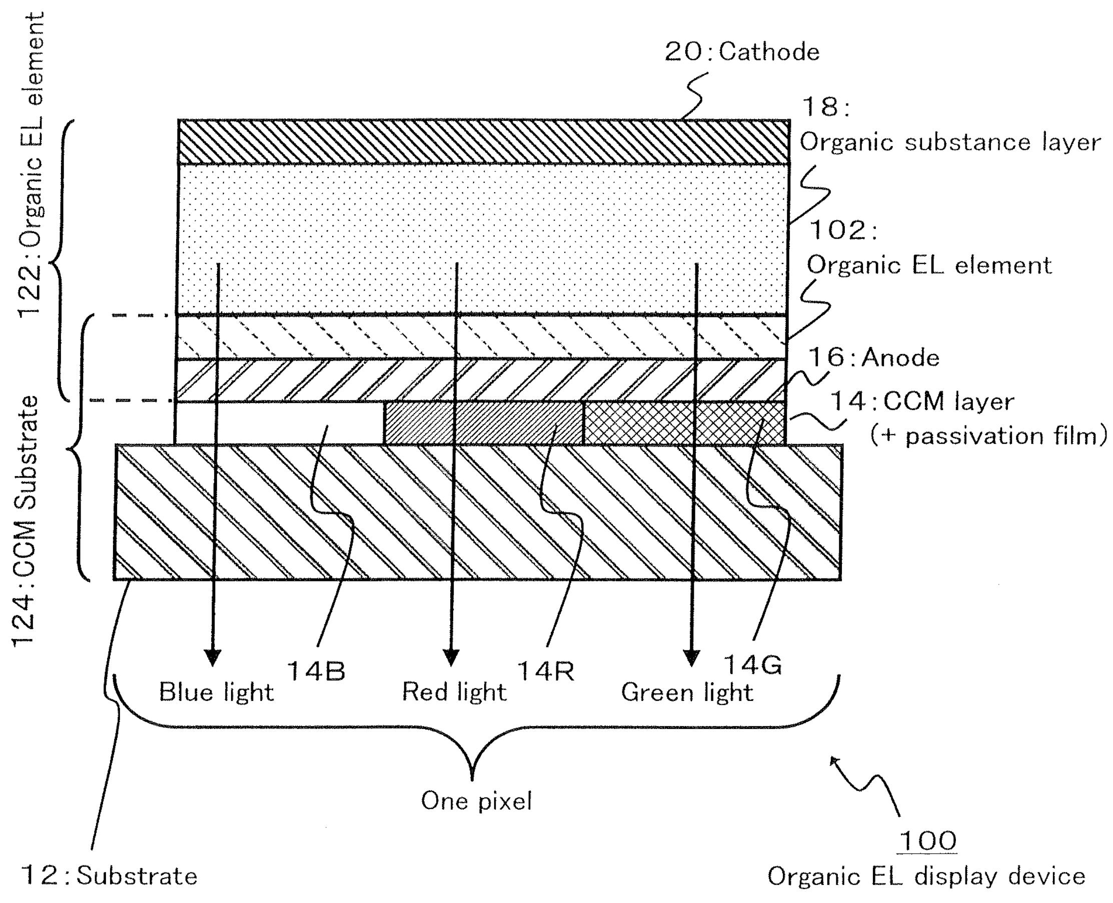

20: Cathode
18:
Organic substance layer
102:
Organic EL element
16: Anode
14: CCM layer
(+ passivation film)
122: Organic EL element
124: CCM Substrate
14B
14R
14G
Blue light
Red light
Green light
One pixel
12: Substrate
100
Organic EL display device

Fig. 2

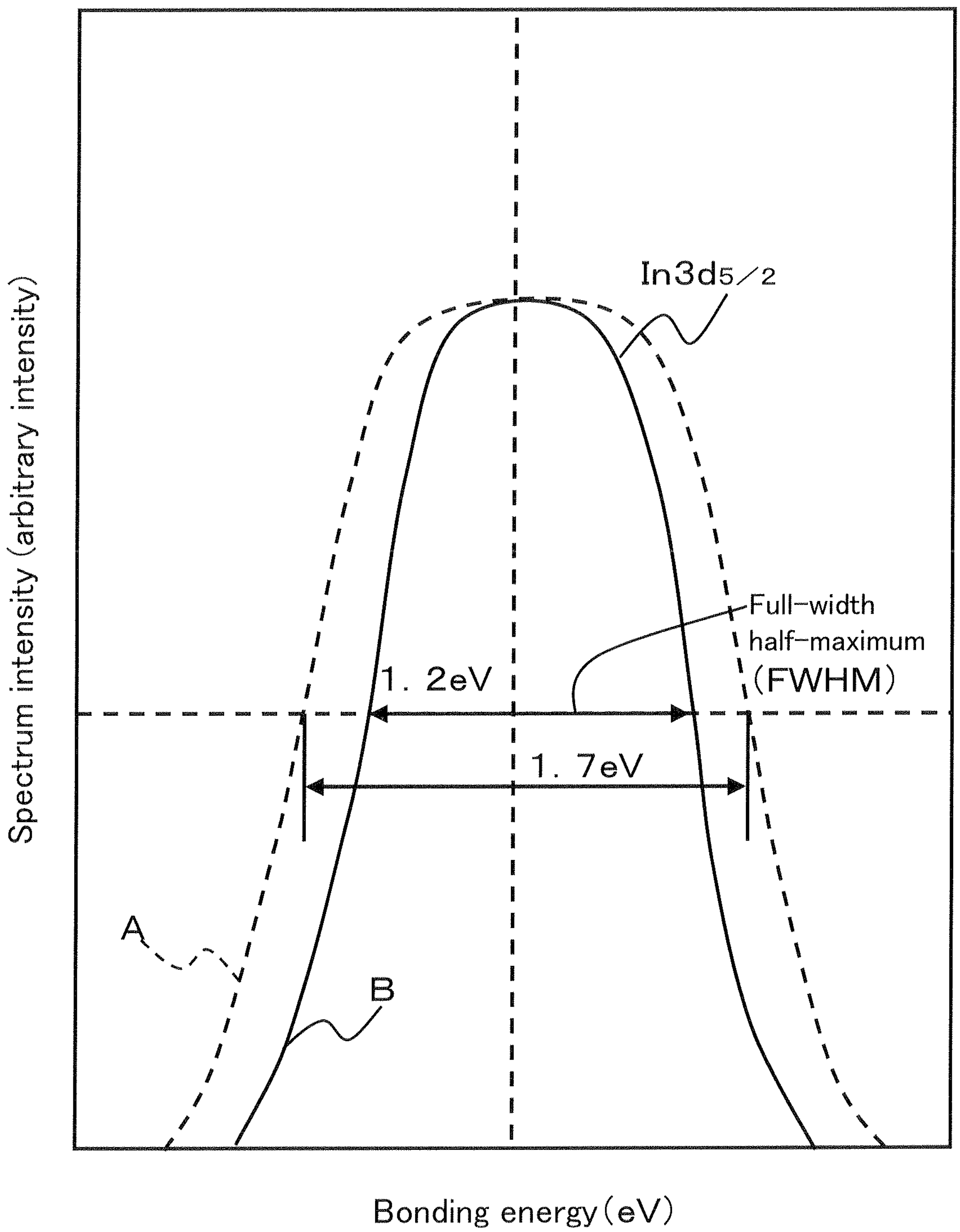
In3d5/2
Full-width
half-maximum
(FWHM)
1. 2eV
1. 7eV
A
B
Spectrum intensity (arbitrary intensity)
Bonding energy (eV)

Fig. 3

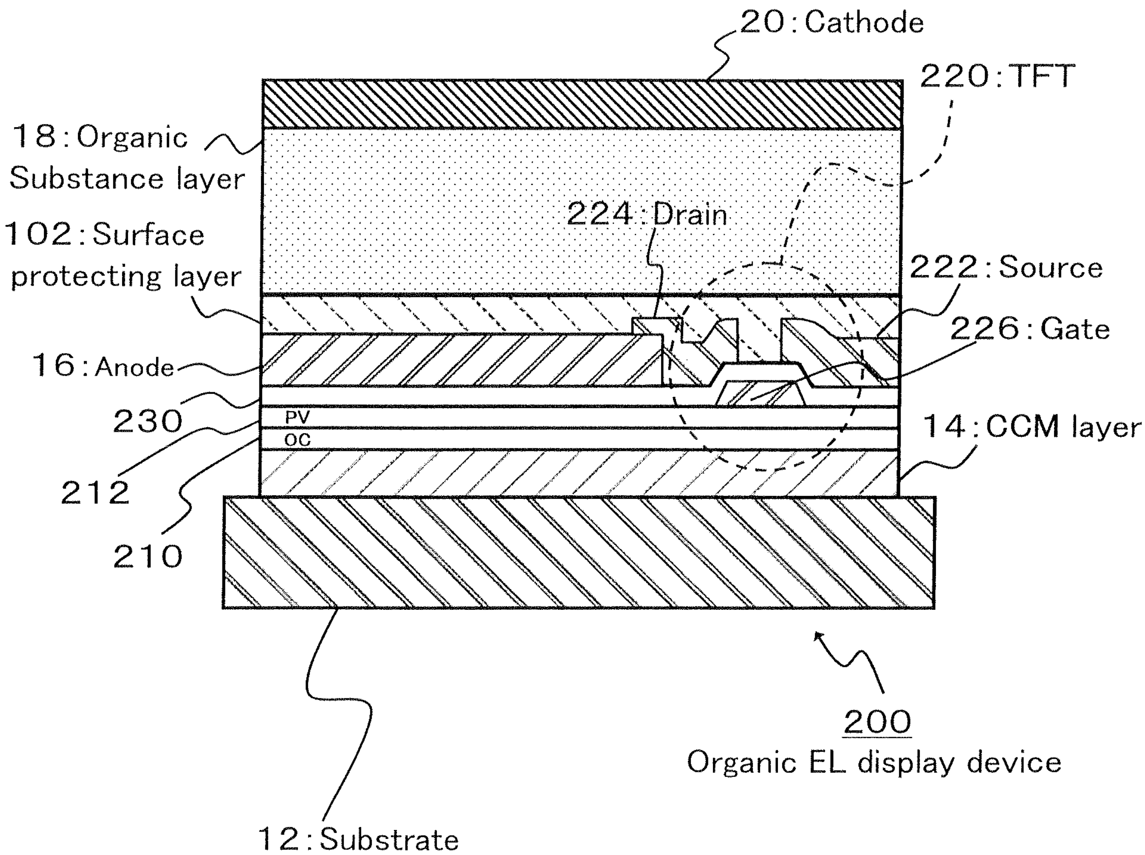
20:Cathode
220:TFT
18:Organic Substance layer
224:Drain
102:Surface protecting layer
222:Source
226:Gate
16:Anode
230
PV
OC
14:CCM layer
212
210
200
Organic EL display device
12:Substrate

Fig. 4

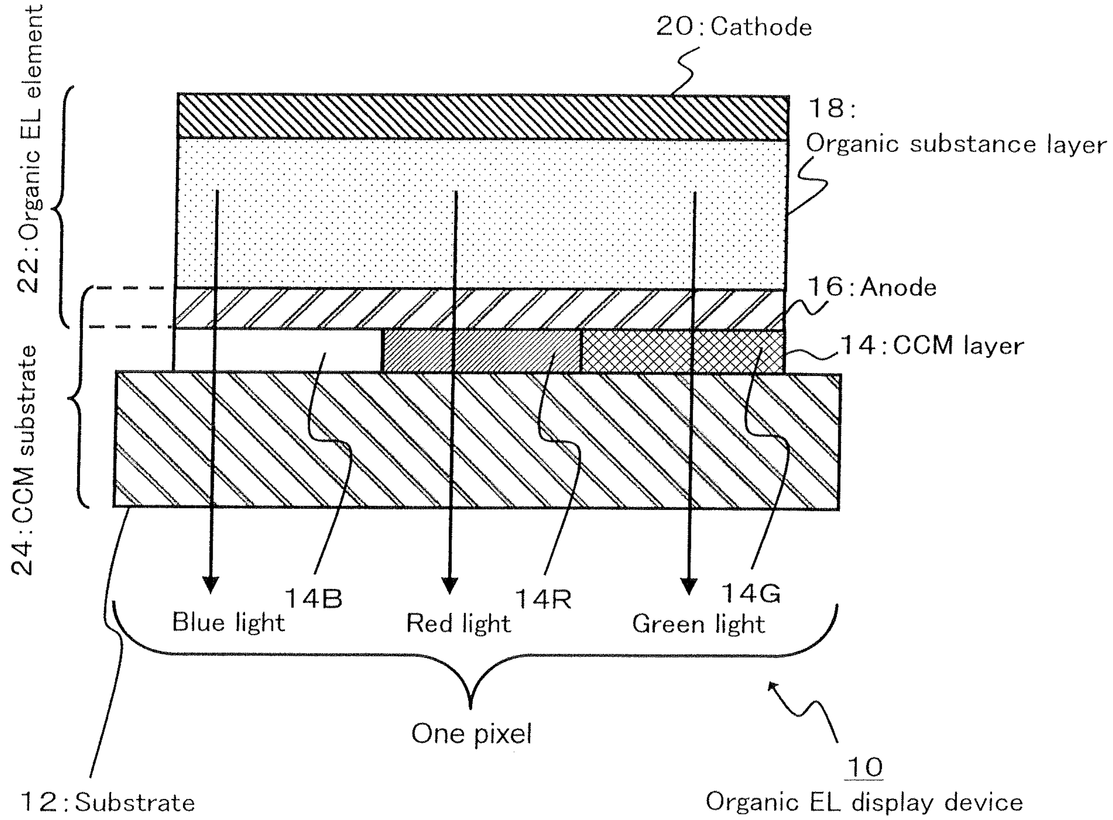
20: Cathode
18:
Organic substance layer
22: Organic EL element
16: Anode
14: CCM layer
24: CCM substrate
14B
Blue light
14R
Red light
14G
Green light
One pixel
10
Organic EL display device
12: Substrate

## INTERNATIONAL SEARCH REPORT

International application No. PCT/JP2004/004971

A. CLASSIFICATION OF SUBJECT MATTER
Int.Cl$^7$ H05B33/28, H05B33/14, H05B33/12, H01B5/14, G09F9/30

According to International Patent Classification (IPC) or to both national classification and IPC

B. FIELDS SEARCHED

Minimum documentation searched (classification system followed by classification symbols)
Int.Cl$^7$ H05B33/28, H05B33/14, H05B33/12, H01B5/14, G09F9/30

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2004 |
| Kokai Jitsuyo Shinan Koho | 1971-2004 | Toroku Jitsuyo Shinan Koho | 1994-2004 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2004-31242 A (Fuji Electric Holdings Co., Ltd.), 29 January, 2004 (29.01.04), Example 1; all drawings (Family: none) | 1-16 |
| Y | JP 2002-170431 A (Idemitsu Kosan Co., Ltd.), 14 June, 2002 (14.06.02), Full text; all drawings & US 2004/0066484 A | 1-16 |

☐ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 20 July, 2004 (20.07.04) | 03 August, 2004 (03.08.04) |

| Name and mailing address of the ISA/ | Authorized officer |
|---|---|
| Japanese Patent Office | |
| Facsimile No. | Telephone No. |

Form PCT/ISA/210 (second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 0072637 A1
- JP 10214683 A
- JP 9324176 A
- JP 9204985 A
- JP 3105898 A
- JP 10260062 A
- JP 9063771 A
- JP 8031573 A
- JP 3210791 A
- JP 3262170 A
- JP 6119973 A
- US 5853905 A
- JP 8288069 A
- JP 11126689 A
- JP 2247278 A
- JP 5198378 A
- US 3112197 A
- US 3189447 A
- JP 3716096 B
- US 3615402 A
- US 3820989 A
- US 3542544 A
- JP 45555 B
- JP 51010983 B
- JP 55017105 B
- JP 56004148 B
- JP 55108667 B
- JP 55156953 B
- JP 56036656 B
- US 3180729 A
- US 4278746 A
- JP 55088064 A
- JP 55088065 A
- JP 49105537 A
- JP 55051086 A
- JP 56080051 A
- JP 56088141 A
- JP 57045545 A
- JP 54112637 A
- JP 55074546 A
- US 3615404 A
- JP 51010105 B
- JP 46003712 B
- JP 47025336 B
- JP 54053435 A
- JP 54110536 A
- JP 54119925 A
- US 3567450 A
- US 3180703 A
- US 3240597 A
- US 3658520 A
- US 4232103 A
- US 4175961 A
- US 4012376 A
- JP 49035702 B
- JP 3927577 B
- JP 55144250 A
- JP 56119132 A
- JP 56022437 A
- DE 1110518
- US 3526501 A
- US 3257203 A
- JP 54110837 A
- US 3717462 A
- JP 54059143 A
- JP 55052063 A
- JP 55052064 A
- JP 55046760 A
- JP 55085495 A
- JP 57011350 A
- JP 57148749 A
- JP 2311591 A
- JP 56046234 A
- JP 61210363 A
- JP 61228451 A
- JP 61014642 A
- JP 61072255 A
- JP 62047646 A
- JP 62036674 A
- JP 62010652 A
- JP 62030255 A
- JP 60093445 A
- JP 60094462 A
- JP 60174749 A
- JP 60175052 A
- US 4950950 A
- JP 2204996 A
- JP 2282263 A
- JP 1211399 A
- JP 632956965 A
- US 4127412 A
- JP 53027033 A
- JP 54058445 A
- JP 54149634 A
- JP 54064299 A
- JP 55079450 A
- JP 61295558 A
- JP 61098353 A

- JP 63295695 A
- US 5061569 A
- JP 4308688 A